(19) Europäisches Patentamt
European Patent Office
Office européen des brevets

(11) Publication number: **0 239 784 B1**

(12) **EUROPEAN PATENT SPECIFICATION**

(45) Date of publication of patent specification: **06.05.92**

(51) Int. Cl.[5]: **C08G 59/06**, C08G 59/30, C08G 59/32, C08G 59/62, C08J 5/24

(21) Application number: **87102617.5**

(22) Date of filing: **24.02.87**

(54) **Curable compositions containing a polyepoxide and a halogenated bisphenol.**

(30) Priority: **24.02.86 US 832428**
**24.09.86 US 911267**

(43) Date of publication of application:
**07.10.87 Bulletin 87/41**

(45) Publication of the grant of the patent:
**06.05.92 Bulletin 92/19**

(84) Designated Contracting States:
**AT BE CH DE ES FR GB IT LI NL SE**

(56) References cited:
**EP-A- 0 214 722**
**EP-A- 0 234 411**
**FR-A- 1 309 346**

**INTERNATINAL POLYMER SCIENCE AND TECHNOLOGY, vol. 12, no. 7, 1985, pages T/9-T/14, Shawbury, Shrewsbury, GB; I. WIESNER: "Preparation of bromoepoxy resins by polyaddition"**

(73) Proprietor: **THE DOW CHEMICAL COMPANY**
**P.O. Box 1967**
**Midland, Michigan 48641-1967(US)**

(72) Inventor: **Berman, Jody R.**
**406 Wisteria**
**Lake Jackson Texas 77566(US)**
Inventor: **Mendoza, Abel**
**3001 Gibson Street**
**Midland Michigan 48640(US)**

(74) Representative: **Casalonga, Axel et al**
**BUREAU D.A. CASALONGA - JOSSE Morassistrasse 8**
**W-8000 München 5(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

EP 0 239 784 B1

## Description

The present invention pertains to curable compositions containing polyglycidyl ethers of a polyphenol and halogenated bisphenols.

Compositions containing glycidyl ethers of bisphenols and halogenated bisphenols have been employed in the preparation of electrical laminates. However, they are usually lacking in one or more properties such as thermal performance, moisture resistance and high temperature mechanical strength and the like.

U. S 4,604,317 issued August 5, 1986 (EP-A-205 455) provides curable compositions which result in cured compositions having an improvement in one or more of the properties selected from thermal stability, glass transition temperature, elevated temperature mechanical strength, moisture resistance, chemical resistance and toughness and the like.

The present invention pertains to a composition comprising

(a) at least one of

(1) at least one epoxy resin represented by formulas I, II, III, IV, V or VI

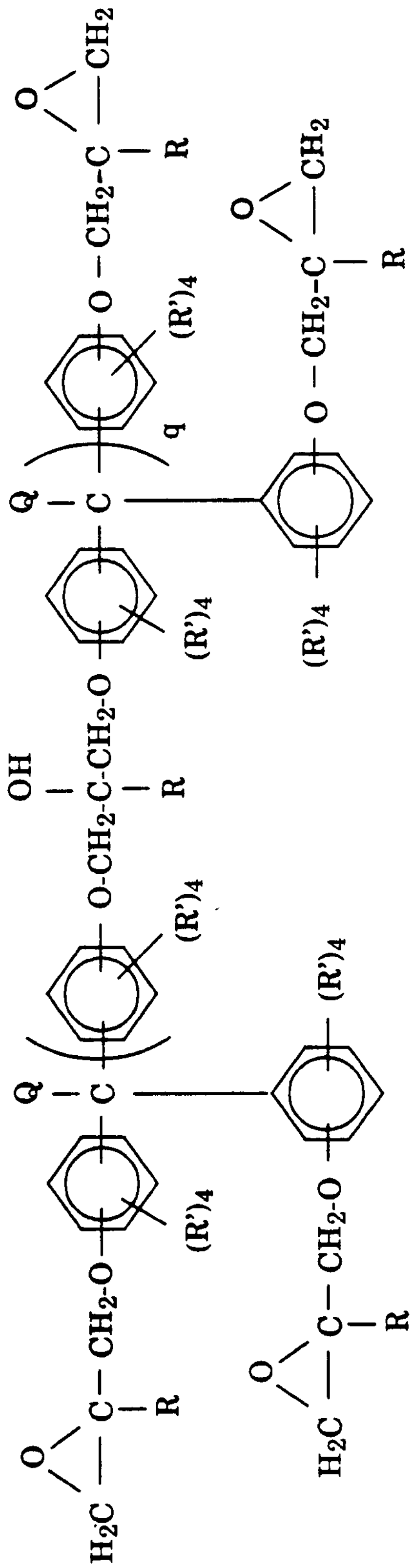

FORMULA I

**FORMULA II**

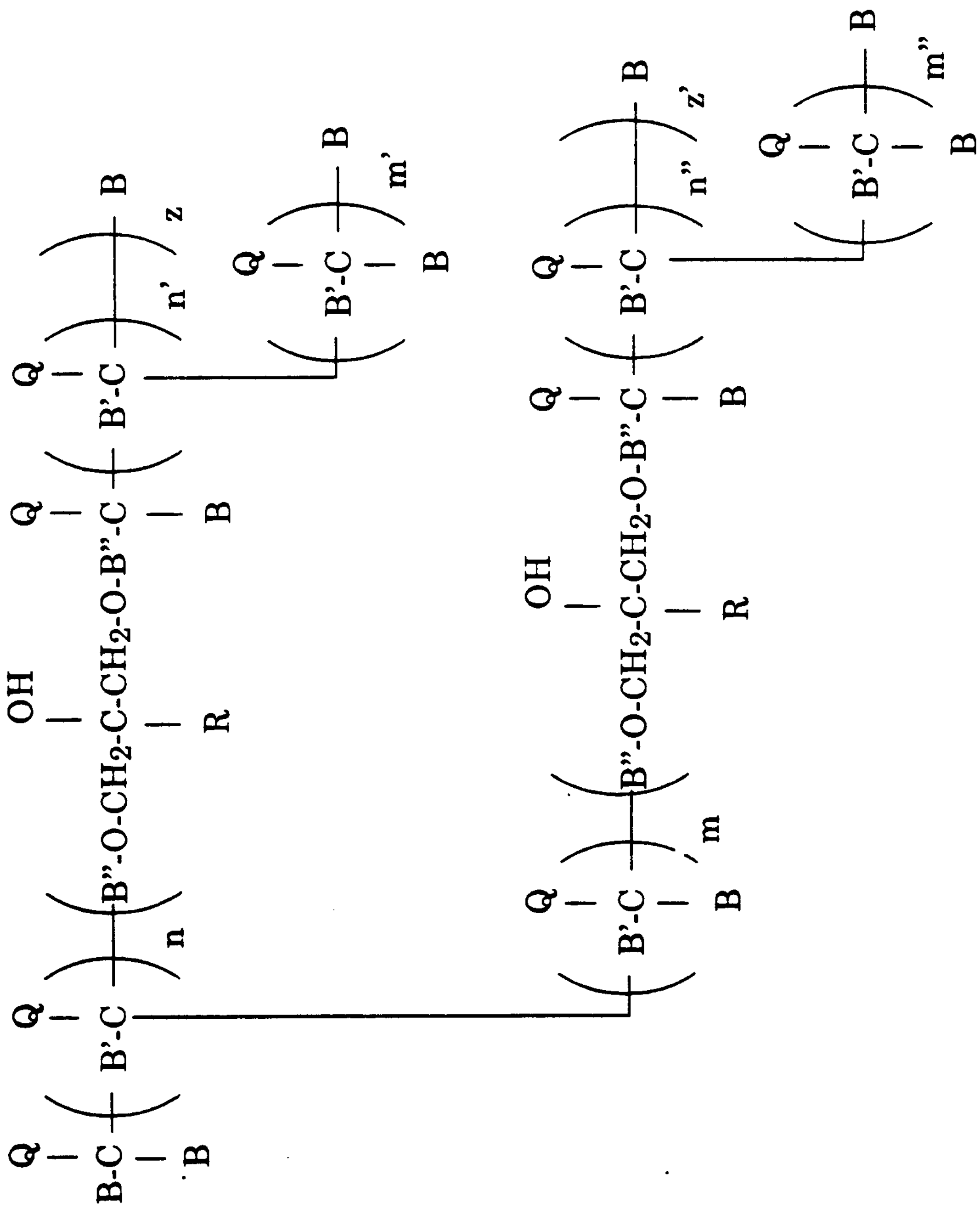

FORMULA III

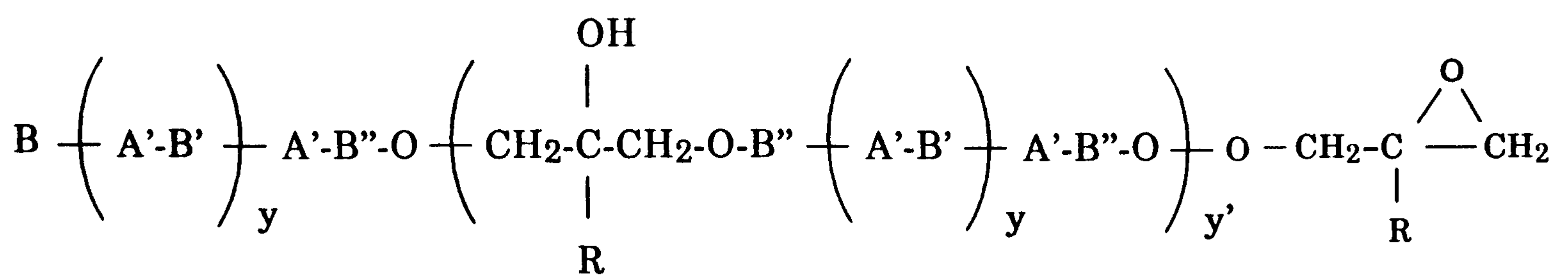

FORMULA IV

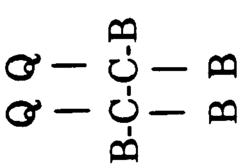

FORMULA VI

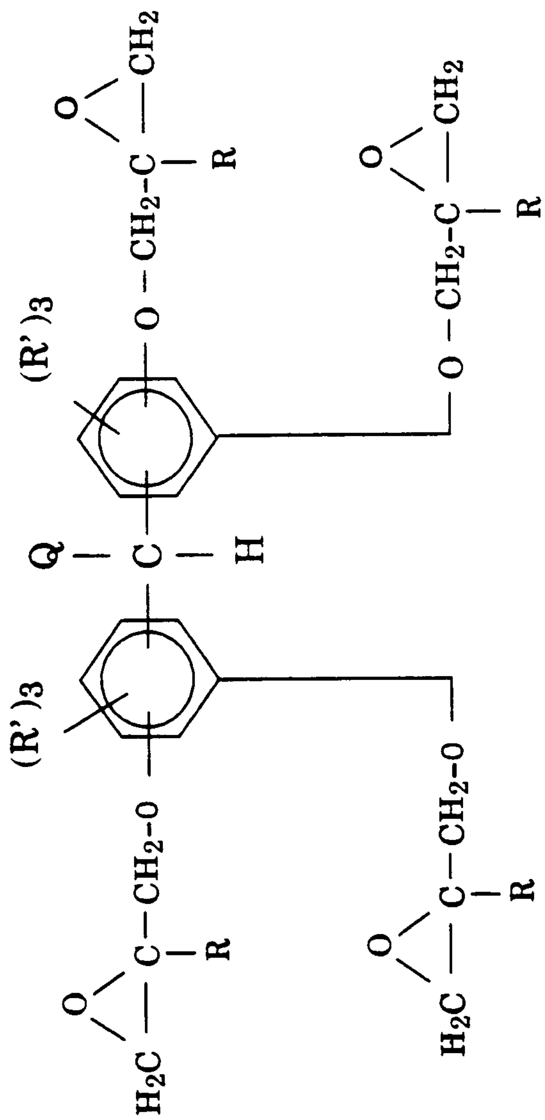

FORMULA V

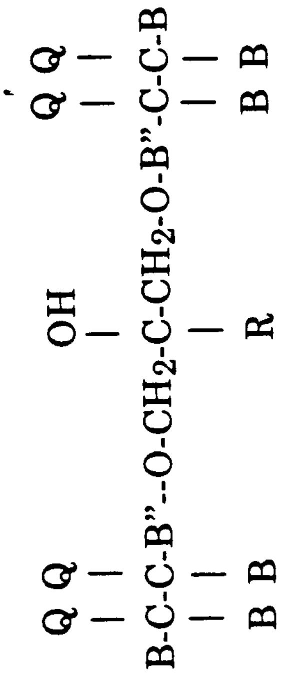

wherein each A′ is independently a divalent hydrocarbyl group having from 1 to 12 carbon atoms, -S-, -S-S-, -SO-, $-SO_2-$, -CO-, or -O-; each B is represented by the formula

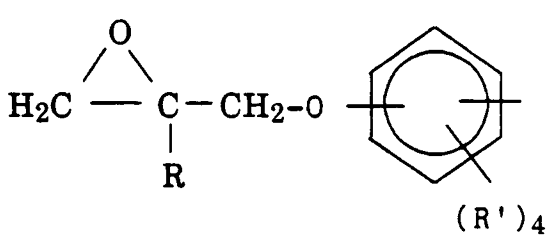

each B′ is represented by the formula

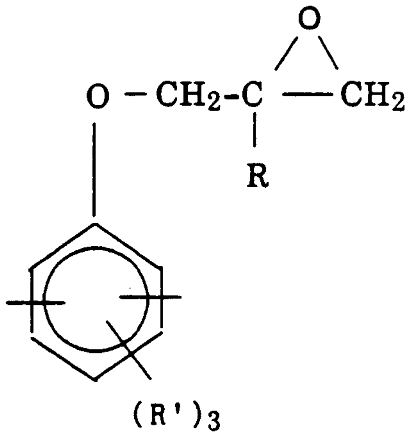

each B″ is represented by the formula

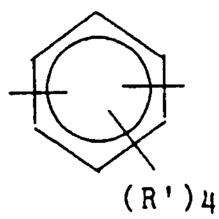

each R is independently hydrogen or an alkyl group having from 1 to 4 carbon atoms; each Q is independently hydrogen or a hydrocarbyl group having from 1 to 10 carbon atoms; each R' is independently hydrogen, a hydrocarbyl or hydrocarbyloxy group having from 1 to 10 carbon atoms or a halogen; m has a value of n-1; m' has a value of n'-1; m" has a value of n"-1; whereby each of m, m' and m'' has at least the value zero each n, n' and n" independently has a value from zero to 3; q has a value from zero to 4, preferably 0.1 to 2, more preferably 0.5 to 1.5; each y independently has an average value from 1 to 5; y' has an average value of from zero to 3 and each z and z' independently has a value from zero to 3;

(2) the reaction product of

(a) at least one epoxy resin as defined in component (A-1); and

(b) at least one dihydric or polyhydric phenol represented by the following formulas VII, VIII or IX

FORMULA VII

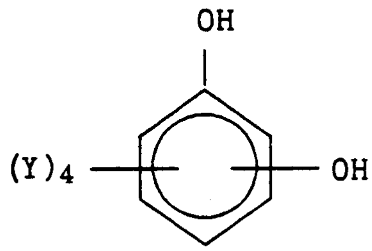

FORMULA VIII

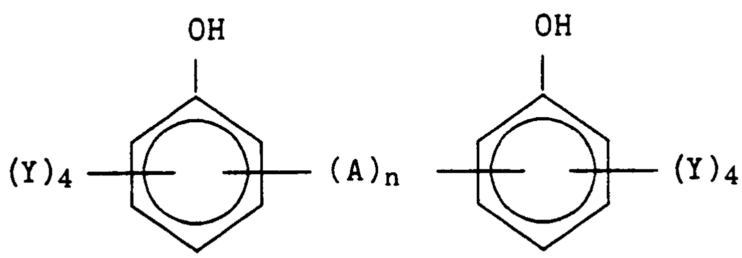

FORMULA (IX)

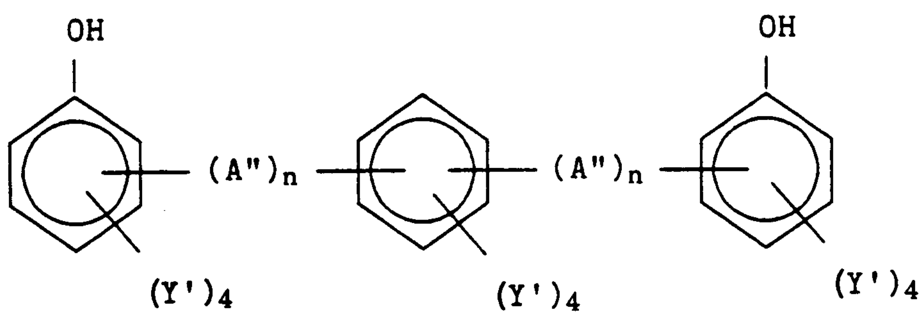

wherein A is a divalent hydrocarbon group having from 1 to 12 carbon atoms, -O-, -S-, -S-S-, -SO-, $-SO_2-$, or -CO-; each A″ is independently a divalent hydrocarbon group having from 1 to 6 carbon atoms, each Y is independently hydrogen, a halogen or a hydrocarbyl or hydrocarbyloxy group having from 1 to 10 carbon atoms; each Y′ is independently hydrogen, a hydrocarbyl or hydrocarbyloxy group having from 1 to 10, preferably from 1 to 4, carbon atoms, a halogen atom or a hydroxyl group; and n has a value of zero or 1; and wherein components (A-2-a) and (A-2-b) are present in quantities such that the ratio of phenolic hydroxyl groups to epoxide groups is from 0.01:1 to 0.5:1, preferably from 0.05:1 to 0.25:1, most preferably from 0.1:1 to 0.2:1; or

(3) mixtures thereof; and

(B) at least one halogenated dihydric or polyhydric phenol represented by formulas X, XI or XII

FORMULA X

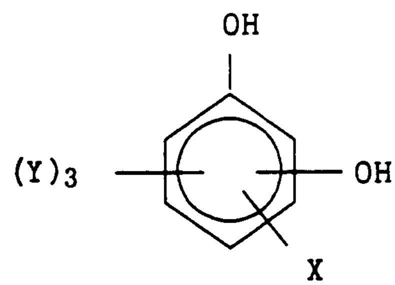

FORMULA XI

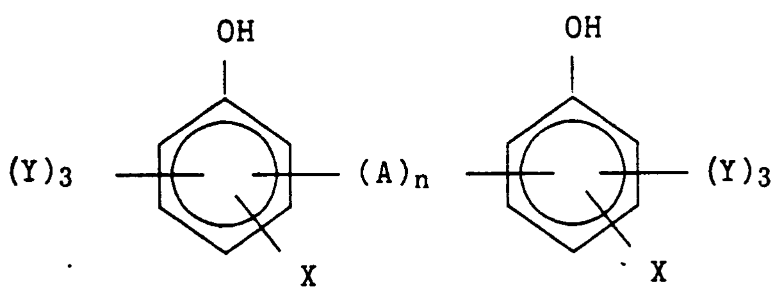

FORMULA XII

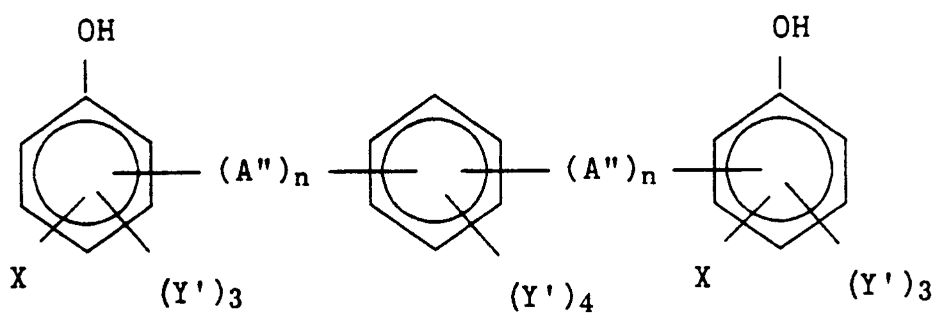

wherein A, A″, Y, Y′ and n are as defined hereinbefore; each X is a halogen, preferably bromine; and wherein components (A) and (B) are present in quantities such that the ratio of phenolic hydroxyl groups to epoxide groups is from 0.7:1 to 1.1:1, preferably from 0.85:1 to 1:1, most preferably from 0.9:1 to 0.95:1; and

characterized by employing as at least a portion of component (B), a halogenated dihydric phenol wherein at least 5, preferably at least 30, most preferably at least 50 percent of the halogen atoms present in component B are in the meta position with respect to the hydroxyl groups.

The composition of the present invention may also contain, if desired,

(C) an effective quantity of at least one catalyst for effecting the reaction between components (A) and (B); and

(D) from zero to 50, preferably from 10 to 45, most preferably from 30 to 40, percent by weight of the combined weight of components (A), (B), (C) and (D) of at least one solvent.

The present invention also pertains to substrates impregnated with the aforementioned compositions and to laminates prepared therefrom.

The present invention provides curable compositions which result in cured compositions having an improvement in one or more of the properties selected from glass transition temperature, resistance to decomposition, moisture resistance, toughness and elevated temperature mechanical strength, and the like.

Particularly suitable epoxy resins which can be employed herein include, for example, the triglycidyl ether of tris(hydroxyphenyl)methane, higher molecular weight homologs thereof, trisepoxides advanced with dihydric phenols, phenol-formaldehyde epoxy novolac resins, cresol-formaldehyde epoxy novolac resins, resorcinol-formaldehyde epoxy novolac resins, phenolglyoxal epoxy novolac resins, and mixtures thereof.

Also suitable as an epoxy resin which can be employed herein are those glycidyl ethers of phenol-aldehyde novolac resins wherein at least a portion of the two functional materials has been removed. These epoxy resins are disclosed in copending US-A-4 649 188.

Particularly suitable dihydric phenols and halogenated dihydric phenols include, for example, bisphenol A, tetrabromobisphenol A, bisphenol S, tetrabromobisphenol S, biphenol, tetrabromobiphenol, tetrabromodihydroxybenzophenone, resorcinol, tetrabromoresorcinol, and mixtures thereof.

Multifunctional phenolic compounds, those having an average functionality of greater than 2, can be employed in this invention together with the diphenolic compounds, if desired, so as to change the cure behavior of the composition. Particularly suitable multifunctional phenolic compounds include, for example, phenol-formaldehyde condensation products having an average functionality of from 3 to 8, phenol-hydroxybenzaldehyde condensation products having an average functionality from of 3 to 7 and cresol-formaldehyde condensation products having an average functionality of from 3 to 8.

Suitable halogenated dihydric phenols and polyhydric phenols having the hologen atoms in the meta position with respect to the hydroxyl groups which can be employed herein include, for example, those represented by the following formulas XIII and XIV

FORMULA XIII

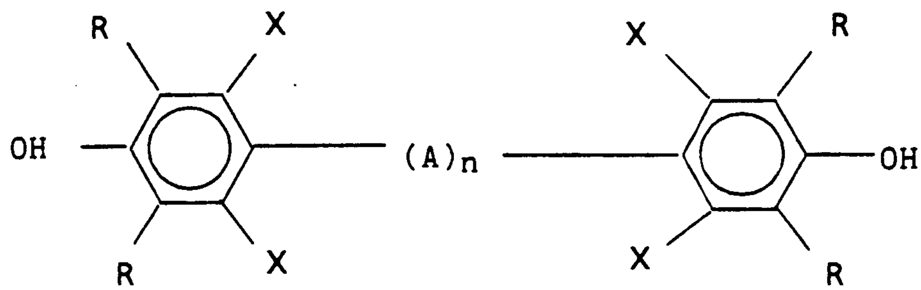

FORMULA XIV

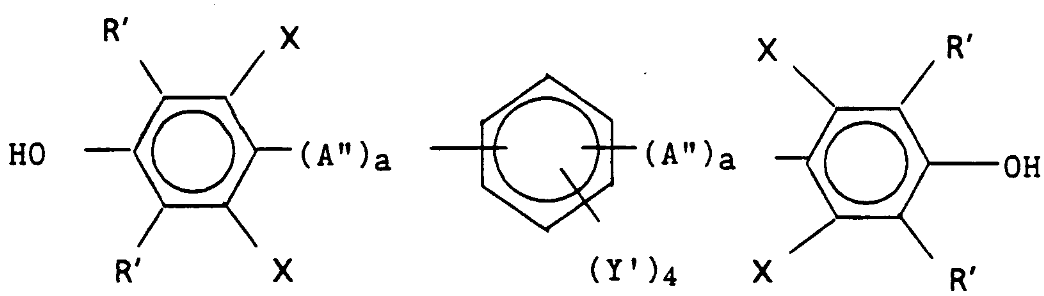

wherein A is a divalent hydrocarbyl group having from 1 to 12, preferably from 1 to 6 carbon atoms, -S-, -S-S-, -SO-, $-SO_2-$, -CO- or -O-; each A″ is independently a divalent hydrocarbon group having from 1 to 6 carbon atoms; each R is independently hydrogen or a hydrocarbyl or hydrocarbyloxy group having from 1 to 10, preferably from 1 to 4 carbon atoms; each X is independently hydrogen, a hydrocarbyl or hydrocarbyloxy group having from 1 to 10, preferably from 1 to 4 carbon atoms or a halogen atom, preferably chlorine or bromine, most preferably bromine, with the proviso that at least one of the X groups is a halogen atom; each Y' independently is hydrogen, a hydrocarbyl or hydrocarbyloxy group having from 1 to 10, preferably from 1 to 4 carbon atoms, a halogen atom or a hydroxyl group; and n has a value of zero or 1.

Particularly suitable halogenated dihydric phenols having at least one halogen atom in the meta position with respect to the hydroxyl group include, for example, 2,2',6,6'-tetrabromo-3,3',5,5'-tetramethyl-4,4'-biphenol, 2,2'6-tribromo-3,3',5,5'-tetramethyl-4,4'-biphenol, 2,2-bis-(2,6-dibromo-3,5-dimethylhydroxyphenyl)-ethane, 2,2-bis-(2,6-dibromo-3,5-dimethylhydroxyphenyl)methane, and combinations thereof.

The halogenated dihydric phenols wherein the halogen atoms are meta with respect to the hydroxyl groups and which also have hydrocarbyl or hydrocarbyloxy groups attached to the ring can be prepared by oxidative coupling of 2,6-dimethylphenol using palladium over carbon catalyst at 80 °C in the presence of oxygen gas. This product is then treated with hydrogen gas and palladium over carbon catalyst to make 3,3',5,5'-tetramethyl-4,4'-biphenol. This product is then reacted with bromine to yield 2,2',6,6'-tetrabromo-3,3',5,5'-tetramethyl-4,4'-biphenol.

Those halogenated dihydric phenols wherein the halogen atoms are meta with respect to the hydroxyl groups and which do not have hydrocarbyl or hydrocarbyloxy groups attached to the ring can be prepared by dealkylation of 2,2′-dibromo-3,3′,5,5′-tetra-t-butyl-4,4′-biphenol to form 2,2′-dibromo-4,4′-biphenol.

Suitable catalysts for effecting the reaction between the epoxy resin and the phenolic hydroxyl-containing compound include, for example, those disclosed in US-A-3,306,872; 3,341,580; 3,379,684; 3,477,990; 3,547,881; 3,637,590; 3,843,605; 3,948,855; 3,956,237; 4,048,141; 4,093,650; 4,131,633; 4,132,706; 4,171,420; 4,177,216; 4,302,574; 4,320,222; 4,358,578; 4,366,295; and 4,389,520.

Particularly suitable catalysts are those quaternary phosphonium and ammonium compounds such as, for example, ethyltriphenylphosphonium chloride, ethyltriphenylphosphonium bromide, ethyltriphenylphosphonium iodide, ethyltriphenylphosphoniumacetate, ethyltriphenylphosphonium diacetate (ethyltriphenylphosphonium acetate•acetic acid complex), ethyltriphenylphosphonium tetrahaloborate, tetrabutylphosphonium chloride, tetrabutylphosphonium acetate, tetrabutylphosphonium diacetate (tetrabutylphosphonium acetate•acetic acid complex), tetrabutylphosphonium tetrahaloborate, butyltriphenylphosphonium tetrabromobisphenate, butyltriphenylphosphonium bisphenate, butyltriphenylphosphonium bicarbonate, benzyltrimethylammonium chloride, benzyltrimethylammonium hydroxide, benzyltrimethylammonium tetrahaloborate, tetramethylammonium hydroxide, tetrabutylammonium hydroxide, tetrabutylammonium tetrahaloborate, and mixtures thereof.

Other suitable catalysts include tertiary amines such as, for example, triethylamine, tripropylamine, tributylamine, 2-methylimidazole, benzyldimethylamine, and mixtures thereof.

Other suitable catalysts include ammonium compounds such as, for example, triethylammonium chloride, triethylammonium bromide, triethylammonium iodide, triethylammonium tetrahaloborate, tributylammonium chloride, tributylammonium bromide, tributylammonium iodide, tributylammonium tetrahaloborate, N,N′-dimethyl-1,2-diaminoethane tetrahaloboric acid complex, and mixtures thereof.

Other suitable catalysts include quaternary and tertiary ammonium, phosphonium, and arsonium adducts or complexes with suitable non-nucleophilic acids such as, for example, fluoboric, fluoarsenic, fluoantimonic, fluophosphoric, perchloric, perbromic, periodic, and mixtures thereof.

The catalysts are suitably employed in any quantity which is sufficient to cause curing of the epoxy resin and the phenolic hydroxyl-containing composition at the temperature employed. Particularly suitable quantities for the catalyst is from about 0.5 to about 5, more suitably from about 0.1 to about 2, most suitably from about 0.2 to about 1, parts of catalyst per 100 parts by weight of epoxy resin contained in the composition.

Suitable solvents which can be employed herein include, for example, ketones, alcohols, glycol ethers and amides, such as, for example, acetone, methyl ethyl ketone, methanol, propylene glycol mono methyl ether and dimethyl formamide.

The compositions of the present invention may also contain, if desired, stabilizers, pigments, dyes, mold release agents, flow control agents, reinforcing agents, fillers, fire retardant agents, rubber modifiers, surfactants, accelerators, reactive diluents, mixtures thereof and the like.

Suitable stabilizers which can be employed herein include, for example, those represented by the formula

FORMULA XV.

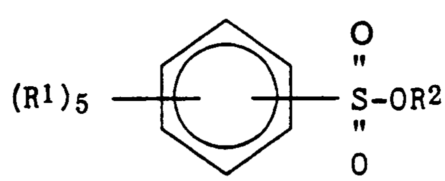

wherein each $R^1$ is independently hydrogen, a hydrocarbyl group having from 1 to 10 carbon atoms or a halogen and $R^2$ is a hydrocarbyl group having from 1 to 10 carbon atoms.

Particularly suitable stabilizers include, for example, methyl p-toluene sulfonate, ethyl p-toluene sulfonate, methyl chlorobenzene sulfonate, and combinations thereof.

The stabilizer component, when used, can be employed in any suitable quantity; however, the usual quantity is from 0.001 to 10, suitably from 0.01 to 2 percent by weight based upon the weight of the epoxy resin component.

The compositions of the present invention are suitable for such applications as structural or electrical laminates or composites, coatings, adhesives, castings, moldings, electronic encapsulations and in potting compositions. Suitable substrates which can be employed herein include, for example, fibers or filaments in woven, matt or non-woven form of glass, carbon, graphite, synthetic fibers, quartz, and combinations thereof.

Electrical laminates are usually prepared from one or more plies of a substrate material impregnated with a curable resin composition with an outer ply of an electrical conducting material.

Suitable electrical conducting materials include, for example, aluminum, copper, gold, platinum and silver.

The following examples are illustrative of the invention but are not to be construed as to limiting the scope thereof in any manner.

Fracture Toughness Measurement ($G_{1C}$)

The method for measuring $G_{1C}$ (fracture toughness or "critical strain energy release rate") is an adaptation of ASTM E-399 for plastics materials from the original usage with metals. The compact tension test is now widespread in usage and is described in the J. Mater. Sci., Vol. 16, 2657, 1981. An individual test piece is cut as an approximate 1" (25.4 mm) square from a flat casting usually of 1/8" (3.175 mm) thickness. A dovetail notch is cut into one edge, centered, about 1/4" (6.25 mm) in depth. Next, a razor blade is inserted into this notch and tapped to produce a precrack. Two holes are then drilled adjacent to the dovetail as indicated in ASTM E-399, allowing the test piece to be pinned into position in the Instron test machine. Extension of the sample now allows the force required to propagate opening of the precrack to be measured, using a test speed of 0.02 inches/minute (0.0085 mm/sec.). This force is used in the equation given in ASTM E-399, along with the required sample dimensions and actual precrack length, to calculate a "stress intensification factor" $K_Q$. This is then combined with the tensile modulus and Poisson's ratio for the material to give the value for $G_{1C}$, usually reported in ergs/cm x 106. A scale comparing typical values for $G_{1C}$ for various plastics and metals is given in reference Lee, L.H., "Physicochemical Aspects of Polymer Surfaces", K.L. Mittal, ed. Plenum Press, New York, N.Y., 1983.

The Tg was determined by Differential Scanning Calorimetry using a calibrated DuPont Instrument (Model No. 912 with a 1090 controller). Samples were run under a nitrogen atmosphere with a heat-up rate of 10 °C per min. (0.1667 °C/sec.).

Coefficient of thermal expansion (CTE) was determined using a calibrated DuPont Thermal Mechanical Analyzer (Model No. 943 with a 1090 controller).

Decomposition properties were determined using a DuPont Thermal Gravimetric Analyzer (Model No. 951 with a DuPont 1090 controller).

Dynamic mechanical properties were measured on a DuPont Dynamic Mechanical Analyzer (Model No. 982 with a DuPont 1090 controller).

The following components were employed in the Examples and Comparative Experiments.

Epoxy Resin A was a polyglycidyl ether of a phenol-orthohydroxybenzaldehyde condensation product having an EEW of 220 and an average functionality of 3.6.

Epoxy Resin B was the reaction product of a diglycidyl ether of bisphenol A having an EEW of 180 and tetrabromobisphenol A wherein the bromine atoms were in the ortho position with respect to the hydroxyl groups. The resultant epoxy resin had an EEW of 430.

Epoxy Resin C was a phenol-formaldehyde epoxy novolac resin having an average functionality of 3.6 and an average EEW of 178.

Epoxy Resin D was a cresol-formaldehyde epoxy novolac resin having an average functionality of 6 and an average EEW of 211. The epoxy resin melt viscosity at 150 °C was 880 cs (880 $mm^2/s$).

Epoxy Resin E was a phenol-formaldehyde epoxy novolac resin having an average functionality of 6, containing less then 1 percent two functional monomer and having an average EEW of 185 (the epoxy was made from a water extracted 91 °C melt point novolac).

Epoxy Resin F was a polyglycidyl ether of a phenol/glyoxal condensation product having an average functionality of 4.2 and an average EEW of 231.

Epoxy Resin G was a polyglycidyl ether of a pheno-orthohydroxybenzaldehyde condensation product having an EEW of 204 and an average functionality of 3.5.

Dihydric Phenol A was 2,2′,6,6′-tetrabromo-3,3′,5,5′-tetramethyl-4,4′-biphenol.

Dihydric Phenol B was 4,4′-isopropylidene-bis-2,6-dibromophenol, also known as tetrabromobisphenol A.

EXAMPLE 1

50 g (0.2273 epoxy equiv.) of Epoxy Resin A was heated to 175°C and degassed. Into the molten resin was stirred 63 g (0.2260 hydroxyl equiv.) of Dihydric Phenol A while maintaining the temperature above 160°C. After 10 minutes, the halogenated phenolic material had dissolved into the resin. The resin system was then degassed and 0.1 g of 2-ethyl-4-methylimidazole was stirred into the mixture. The mixture was then poured into an aluminum mold, which had been sprayed with fluoroglide to prevent sticking, so as to produce cured castings having a thickness of 1/8" (3.175 mm). The mold was placed into an oven for 1 hour at 180°C and 2 hours at 230°C. The results are given in Table I.

COMPARATIVE EXPERIMENT A

56.87 g (0.209 hydroxyl equiv.) of Dihydric Phenol B in which all of the bromine atoms were in the ortho position with respect to the hydroxyl groups was stirred into 50 g (0.238 epoxy equiv.) of Epoxy Resin A at 175°C. After heating for 10 minutes, the resin solution was degassed and 0.1 g of 2-ethyl-4-methylimidazole was stirred into the mixture. The resin was then poured into an aluminum mold and cured as in Example 1. The results are given in Table I.

COMPARATIVE EXPERIMENT B

50 g (0.116 hydroxyl equiv.) of Epoxy Resin B was heated to 150°C. 5.74 g of methylene dianiline (49.5 amine hydrogen equiv.) was stirred therein and then poured into an aluminium mold. as in Example 1 and cured in an oven at 175°C for 2 hours. The results are given in Table I.

TABLE I

| Example or Comparative Experiment | Tg °C | Dynamic Decomposition Temperature °C |
|---|---|---|
| Ex. 1 | 220 | 365 |
| Comp. Expt. A | 190 | 315 |
| Comp. Expt. B | 160 | 310 |

EXAMPLE 2

A. Varnish Formulation

1434 g (4.889 equiv.) of a 75% solution of Epoxy Resin A in methyl ethyl ketone
2339 g (4.614 equiv.) of a 55% solution of Dihydric Phenol A in methanol
7.532 g of a 5% solution of 2-methylimidazole in dimethylformamide
200 g of acetone

The varnish formulation had a viscosity of 19 seconds measured in a No. 2 Zahn cup at 75°F. The formulation also had a gel time of 189 seconds at 171°C.

B. Preparation of Preimpregnated Substrate

Burlington Style 7628 glass cloth was impregnated with the varnish formulation of Example 2-A in a forced air vertical treater having a total length of 26 feet (7.9 meters) with the first 19.5 feet (5.9 meters) heated to 350°F (176.7°C) at a rate of 12 feet per min. (61 mm/sec.). The resin contained in the impregnated glass cloth had a 136 second gel time at 171°C. The resultant impregnated cloth had a resin content of 39% by weight.

C. Preparation of Laminate

Both unclad (no copper) and one sided copper clad, 0.062" (1.57 mm) thick laminates were pressed from aforementioned prepreg. Eight 12" x 12" (304.8 cm x 304.8 cm) plies were pressed into laminate form. The copper foil was a 1-ounce (28.35 g) zinc oxide treated material. The laminates were pressed in a preheated Wabash press at 350 °F (176.7 °C) and 500 psi (3447 kPa) for 1 hour.

The unclad laminate had the following properties:

1. Tg = 185 °C.
2. Dynamic decomposition temperature was 380 °C (run at 3 °C/min., 0.05 °C/sec.).
3. Decomposition stability at 290 °C over a 60 min. period was 100% stable (no weight loss).
4. The relative blister resistance was determined by placing 3 (2" x 4") (5 x 10 cm) unclad laminate coupons in a pressure pot at 15 psi (103 kPa) steam pressure.
5. Tg = 220 °C after 1 hour post cure at 225 °C for 2 hours. After 2 hours, the coupons were removed, externally dried and dipped in molten solder at 500 °F (260 °C) for 20 seconds. Each side of the 3 coupons was then inspected for any delamination blisters. The results were reported as number of sides with no blisters divided by total number of sides. This system had a perfect 6/6 or 100% passed.

The clad laminate had a copper peel strength of 5.6 to 6.4 lbs./in. (1120.8 N/m).

COMPARATIVE EXPERIMENT C

5.140 g (0.0243 equiv.) of Epoxy Resin D was blended with 6.615 g (0.0243 equiv.) of Dihydric Phenol B and 0.100 g of a 10% solution of benzyldimethylamine (BDMA) at 175 °C until a complete solution occurred. The resulting homogeneous composition was cured at 175 °C for 2 hours and 230 °C for 90 minutes. Physical properties of the final clear casting is reported in Table II.

COMPARATIVE EXPERIMENT D

4.981 g (0.02798 equiv.) of Epoxy Resin C, 7.683 g (0.0282 equiv.) of Dihydric Phenol B and 0.100 g of BDMA were blended and cured as described in Comparative Experiment C. Physical properties of the final clear casting is reported in Table II.

EXAMPLE 3

5.838 g (0.0328 equiv.) of Epoxy Resin C, 9.221 g (0.0332 equiv.) of Dihydric Phenol A and 0.100 g of a 10% solution BDMA were blended and cured as described in Comparative Experiment C. Physical properties of the final clear casting is reported in Table II.

EXAMPLE 4

5.662 g (0.0278 equiv.) of Epoxy Resin G, 7.716 g (0.0278 equiv.) of Dihydric Phenol A and 0.108 g of a 10% solution BDMA in methanol were blended and cured as described in Comparative Experiment C. Physical properties of the final clear casting is reported in Table II.

EXAMPLE 5

4.618 g (0.02496 equiv.) of Epoxy Resin E, 6.958 g (0.0250 equiv.) of Dihydric Phenol A and 0.100 g of a 10% solution BDMA were blended and cured as described in Comparative Experiment C. Physical properties of the final clear casting is reported in Table II.

EXAMPLE 6

5.425 g (0.0235 equiv.) of Epoxy Resin F, 6.520 g (0.0235 equiv.) of Dihydric Phenol A and 0.100 g of a 10% solution BDMA were blended and cured as described in Comparative Experiment C.Physical properties of the final clear casting is reported in Table II.

TABLE II

| Example or Comp. Expt. | Tg (DSC)[1] | Tg (DMA)[2] | Tg (DMA)[3] | Elevated Temperature Mechanical Strength[4] |
|---|---|---|---|---|
| Ex.3 | 157 °C | 168 °C | 157 °C | 165 °C |
| Ex.4 | 208 °C | 221 °C | 207 °C | 217 °C |
| Ex.5 | 209 °C | 219 °C | 200 °C | 210 °C |
| Ex.6 | 214 °C | 232 °C | 216 °C | 220 °C |
| Comp. Expt C | 159 °C | 170 °C | 160 °C | 170 °C |
| Comp. Expt. D | 141 °C | 153 °C | 140 °C | 147 °C |

[1]The glass transition is reported as the inflection value of the heat flow curve recorded during a dynamic scan at 10 °C/minute on a Differential Scanning Calorimeter.
[2]The glass transition temperature is reported from the peak of the damping curve which is recorded from the resonance data on a dynamic mechanical spectrometer heating at a rate of 3 °C/minute (0.05 °C/s).
[3]The glass transition temperature is from the onset of the storage modulus curve which is recorded from a dynamic mechanical spectrometer heating at a rate of 3 °C/minute (0.05 °C/s).
[4] The value reported is the temperature at which 50% of the storage modulus is lost as recorded on a dynamic mechanical spectrometer heating at a rate of 3 °C/minute (0.05 °C/s).

## Claims

**Claims for the following Contracting States : BE, CH, DE, FR, GB, IT, LI, NL, SE**

**1.** A composition comprising
(A) at least one of

(1) at least one epoxy resin represented by the following formulas I, II, III, IV, V or VI

FORMULA I

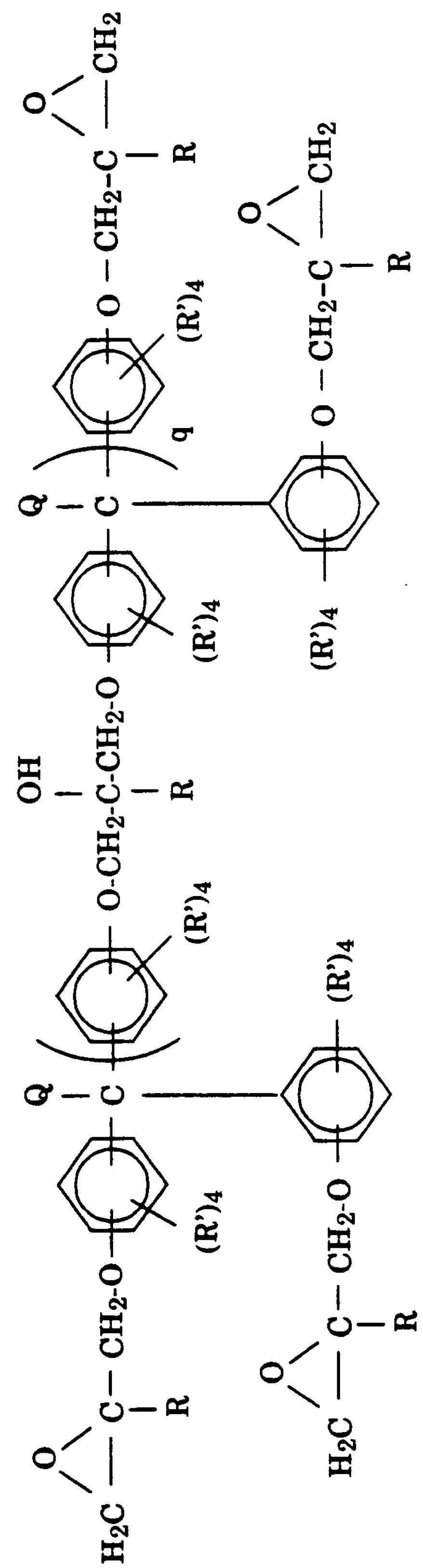

FORMULA II

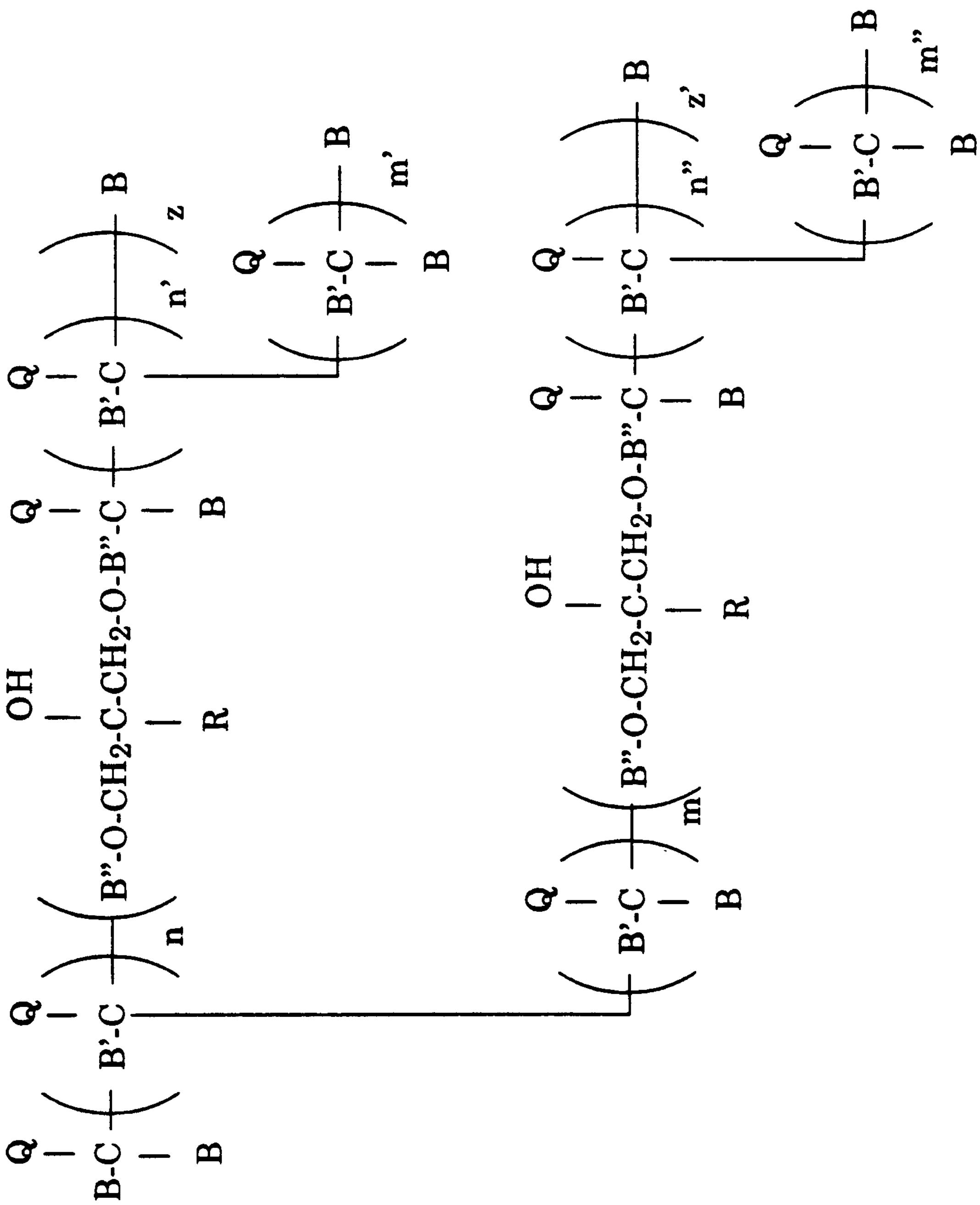

FORMULA III

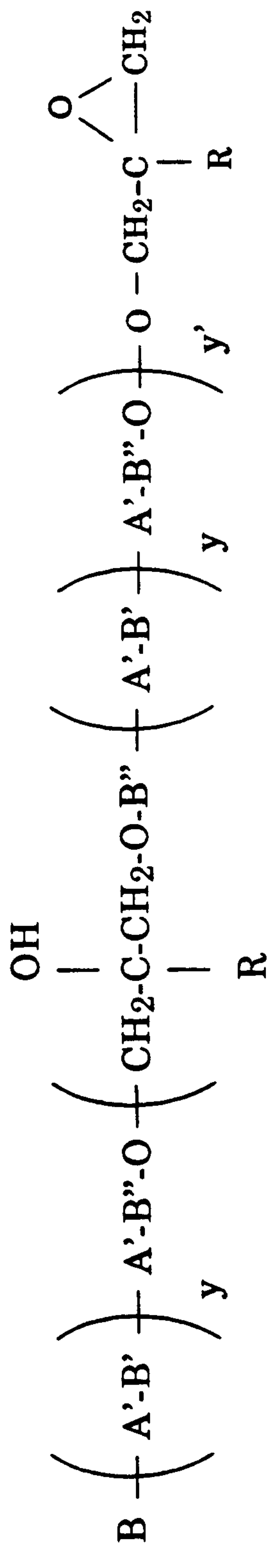

FORMULA IV

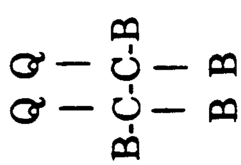

FORMULA V

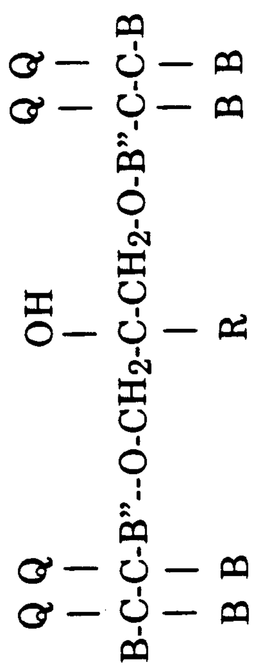

FORMULA VI

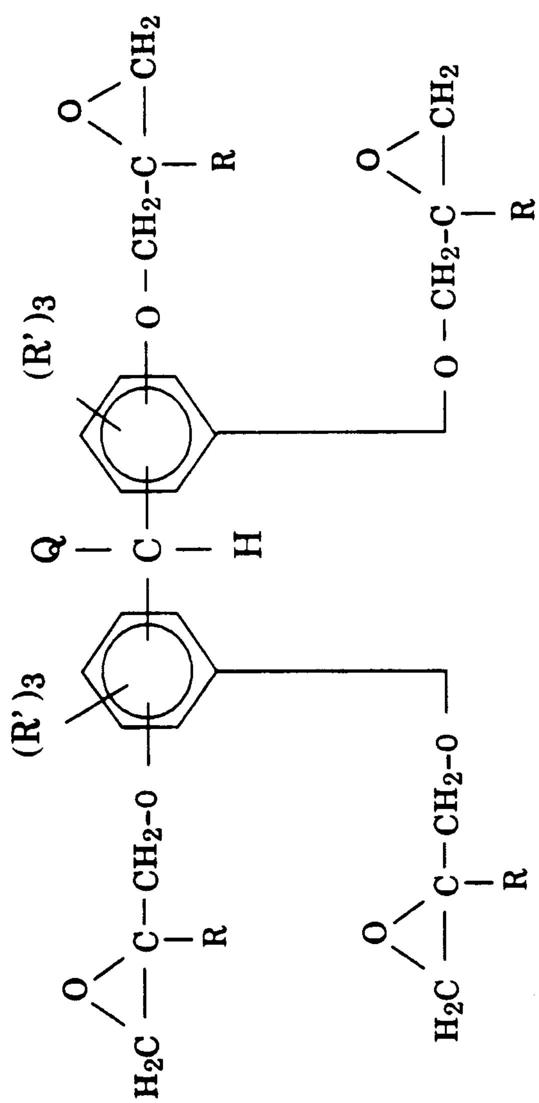

wherein each A′ is independently a divalent hydrocarbyl group having from 1 to 12 carbon atoms, -S-, -S-S-, -SO-, $-SO_2-$, -CO- or -O-;

each B is represented by the formula

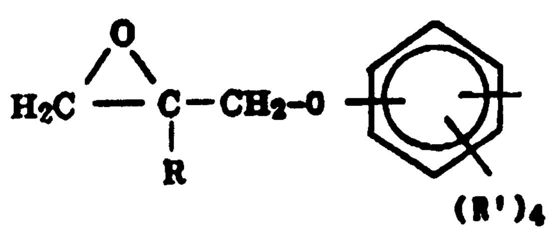

each B′ is represented by the formula

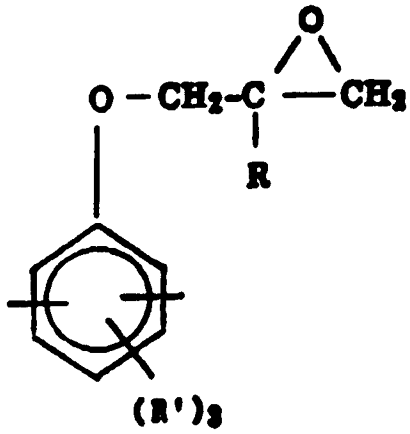

each B″ is represented by the formula

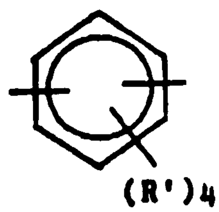

each R is independently hydrogen or an alkyl group having from 1 to 4 carbon atoms; each Q is independently hydrogen or a hydrocarbyl group having from 1 to 10 carbon atoms; each R′ is independently hydrogen, a hydrocarbyl or hydrocarbyloxy group having from 1 to 10 carbon atoms or a halogen; m has a value of n-1; m′ has a value of n′-1; m″ has a value of n″-1 whereby each of m, m′ and m″ has at least the value zero; each n, n′ and n″ independently has a value from zero to 3; q has a value from zero to 4; each y independently has an average value from 1 to 5; y′ has an average value of from zero to 3 and each z and z′ independently has a value from zero to 3;

(2) the reaction product of

(a) at least one epoxy resin as defined in component (A-1) and

b) at least one dihydric or polyhydric phenol represented by the following formulas VII, VIII or IX

FORMULA VII

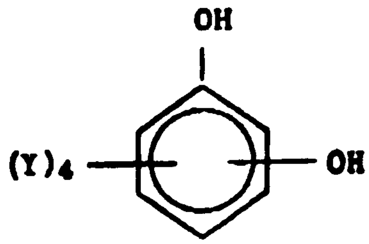

FORMULA VIII

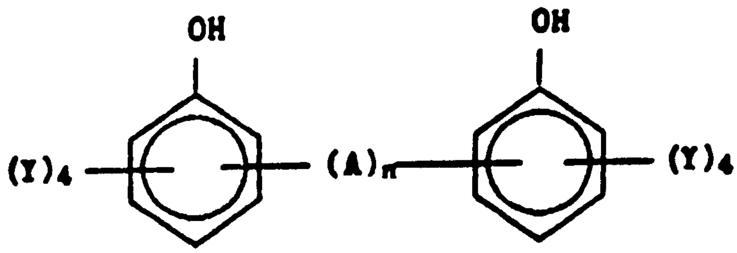

FORMULA (IX)

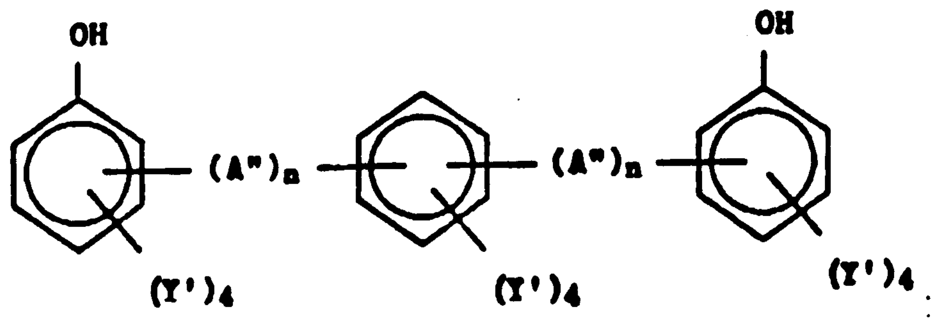

wherein A is a divalent hydrocarbon group having from 1 to 12 carbon atoms, -O-, -S-, -S-S-, -SO-, $-SO_2-$, or -CO-; each Y is independently hydrogen, a halogen or a hydrocarby or hydrocarbyloxy group having from 1 to 10 carbon atoms; each A″ is independently a divalent hydrocarbon group having from 1 to 6 carbon atoms; each Y′ is independently hydrogen, a hydrocarbyl or hydrocarbyloxy group having from 1 to 10, preferably from 1 to 4 carbon atoms, a halogen atom or a hydroxyl group; and n has a value of 0 or 1; and wherein components (A-2-a) and (A-2-b) are present in quantities such that the ratio of phenolic hydroxyl groups to epoxide groups is from 0.01:1 to 0.5:1; or

(3) mixtures thereof; and

(B) at least one halogenated dihydric phenol represented by the following formulas X, XI or XII

**FORMULA X**

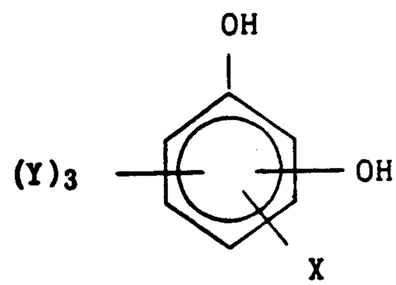

**FORMULA XI**

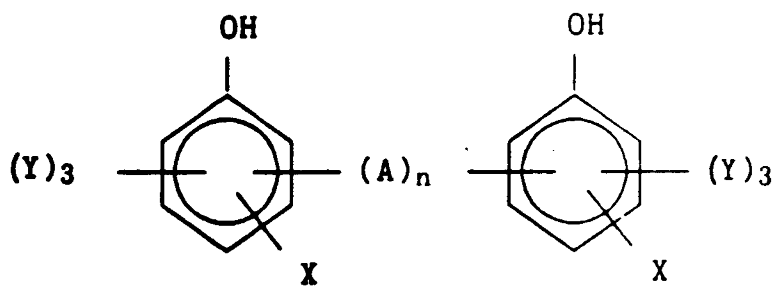

**FORMULA XII**

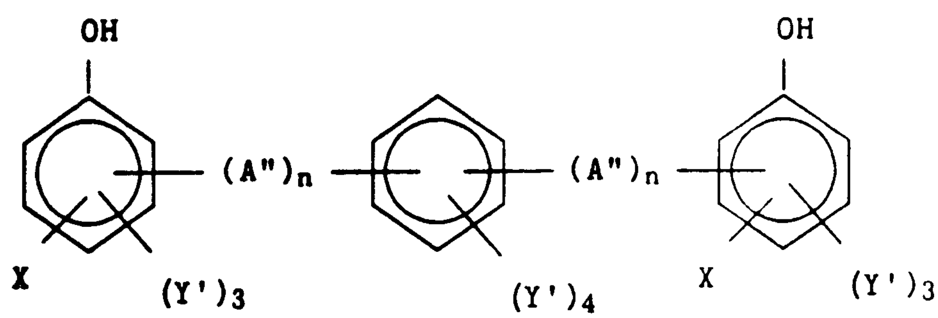

wherein A, A″, Y, Y′ and n are as defined above; each X is a halogen; and wherein components (A) and (B) are present in quantities such that the ratio of phenolic hydroxyl groups to epoxide groups is from 0.7:1 to 1.1:1; characterized by employing as at least a portion of component (B) a halogenated dihydric phenol wherein at least 5 weight percent of the halogen atoms present in component (B) are in the meta position with respect to the hydroxyl groups.

**2.** A composition of Claim 1 wherein components (A) and (B) are present in quantities such that the ratio of phenolic hydroxyl groups to epoxide groups is from 0.85:1 to 1:1; and a stabilizing quantity of a stabilizer represented by the formula

FORMULA XV.

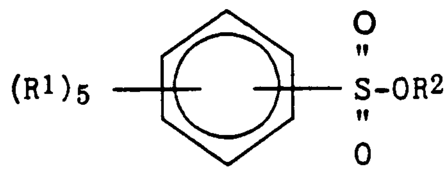

wherein each $R^1$ is independently hydrogen, a hydrocarbyl group having from 1 to 10 carbon atoms or a halogen, and $R^2$ is a hydrocarbyl group having from 1 to 10 carbon atoms is present; characterized in that;at least 30 weight percent of the halogen atoms present in component (B) are in the meta position with respect to the hydroxyl groups.

**3.** A composition of Claim 2 wherein components (A) and (B) are present in quantities such that the ratio of phenolic hydroxyl groups to epoxide groups is from 0.9:1 to 0.95:1; and said stabilizer is present in an amount of from 0.001 to 10 percent by weight of the weight of component (A); characterized in that at least 50 weight percent of the halogen atoms present in component (B) are in the meta position with respect to the hydroxyl groups.

**4.** A composition of Claim 1 or Claim 2 wherein component (A) is component (A-1) represented by formula I or II wherein Q, R and R′ are hydrogen; q has an average value of from 0.1 to 2 and component (B) is represented by formula XI wherein A is a divalent hydrocarbyl group having from 1 to 6 carbon atoms, and each X is bromine.

**5.** A composition of Claim 1 or Claim 2 wherein component (A) is component (A-1) represented by formula III wherein A′ has from 1 to 4 carbon atoms and each R and R′ is hydrogen and component (B) is represented by formula XI wherein A is a divalent hydrocarbyl group having from 1 to 6 carbon atoms and each X is bromine.

**6.** A composition of Claim 1 or Claim 2 wherein component (A) is component (A-1) represented by formulas IV or V wherein each Q, R and R′ is hydrogen and component (B) is represented by formula XI wherein A is a divalent hydrocarbyl group having from1 to 6 carbon atoms and each X is bromine.

**7.** A composition of Claim 1 or Claim 2 wherein component (A) is component (A-1) represented by formula VI wherein each Q and R′ is hydrogen and component (B) is represented by formula XI wherein A is a divalent hydrocarbyl group having from 1 to 6 carbon atoms and each X is bromine.

**8.** A composition of anyone of Claims 4-7 wherein component (B) is 2,2′,6,6′-tetrabromo-3,3′,5,5′-tetramethyl-4,4′-biphenol or 2,2′,6-tribromo-3,3′,5,5′-tetra-methyl-4,4′-biphenol or 4,4′-methylene-bis-3,5-dibromo- -2,6-dimethylphenol, or mixture thereof and said stabilizer is methyl p-toluene sulfonate.

**9.** A composition which comprises (I) a composition of any one of Claims 1-8 and (II) a catalytic quantity of at least one catalyst for effecting the reaction between components (I-A) and (I-B).

**10.** An electrical laminate prepared from one or more layers of a substrate impregnated with a composition of Claim 9.

**Claims for the following Contracting States : AT, ES**

**1.** A method for preparing a composition said composition comprising
(A) at least one of

(1) at least one epoxy resin represented by the following formulas I, II, III, IV, V or VI

FORMULA I

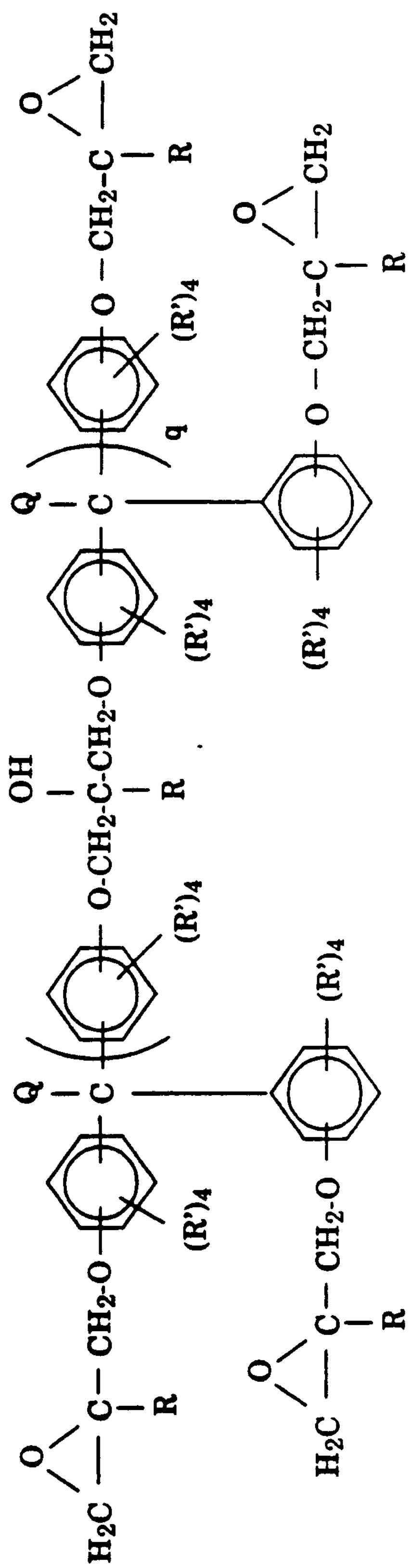

FORMULA II

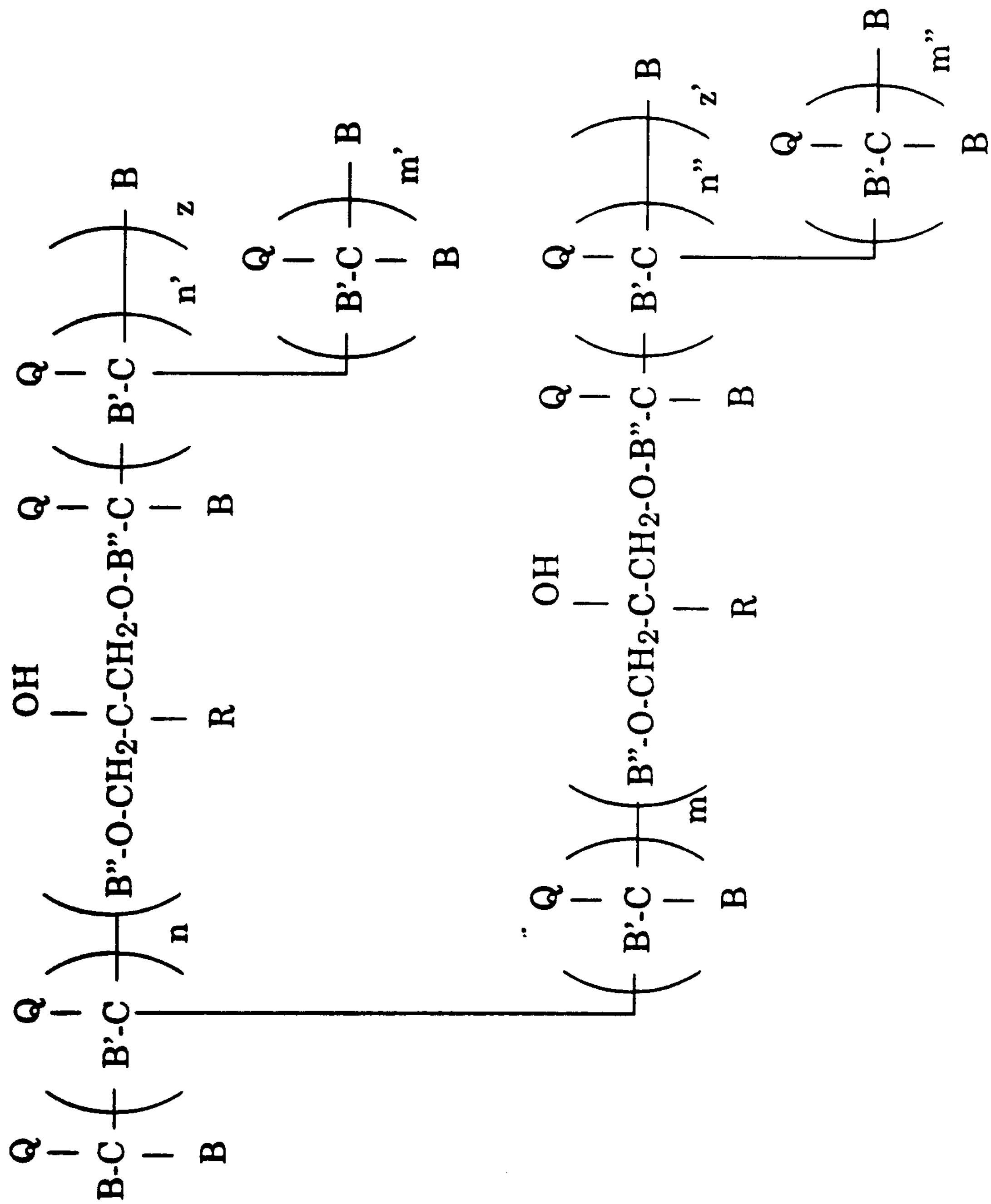

FORMULA III

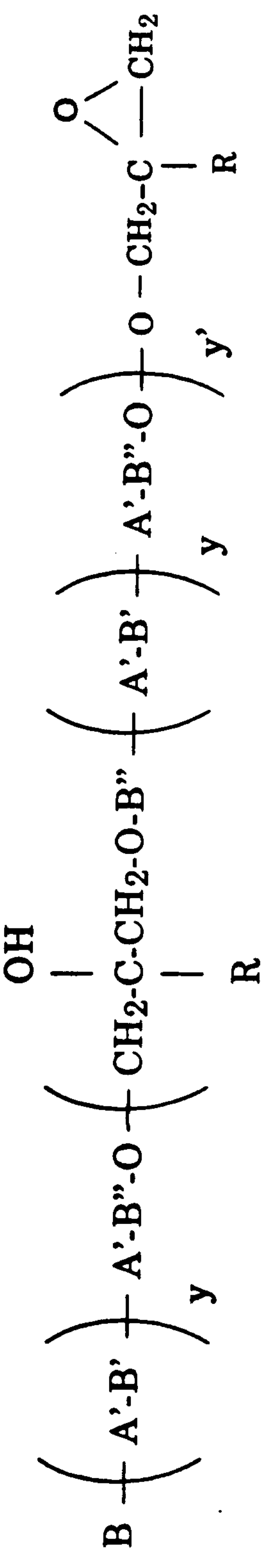

FORMULA IV

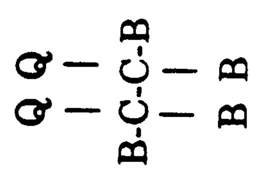

FORMULA V

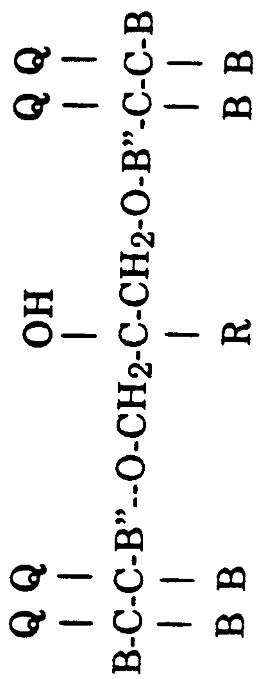

FORMULA VI

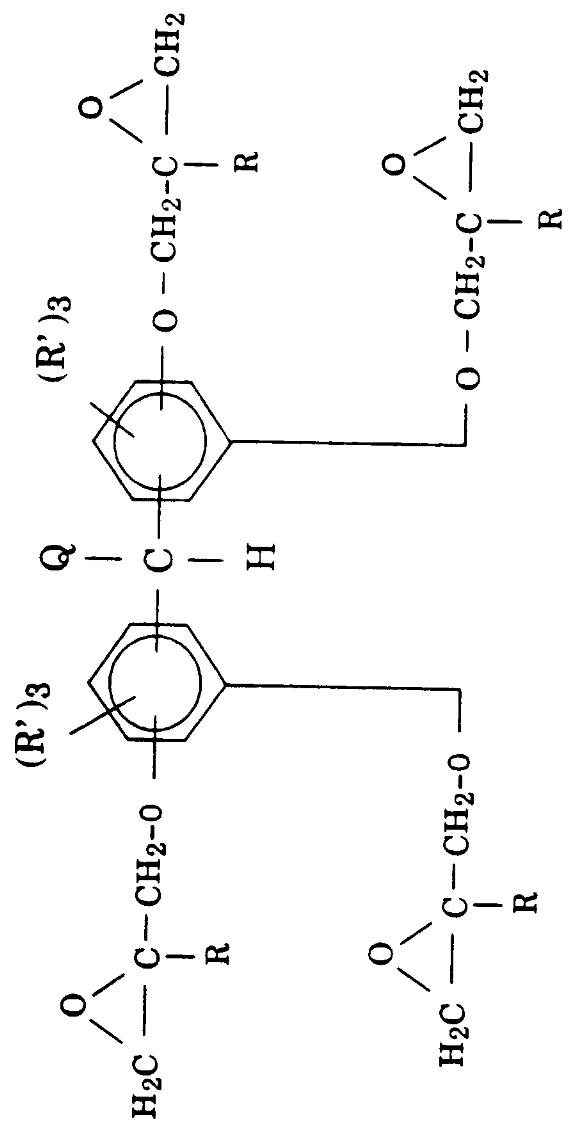

wherein each A′ is independently a divalent hydrocarbyl group having from 1 to 12 carbon atoms, -S-, -S-S-, -SO-, $-SO_2-$, -CO- or -O-;
each B is represented by the formula

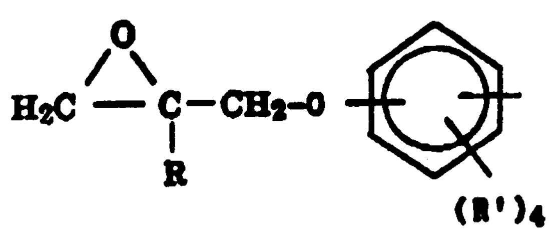

each B′ is represented by the formula

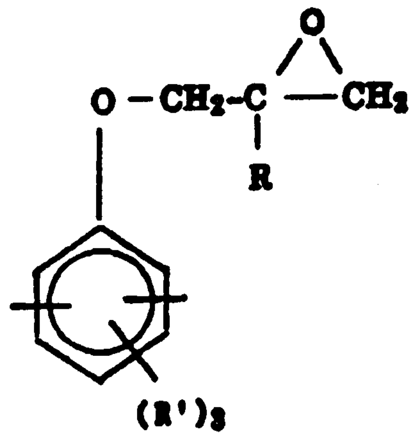

each B″ is represented by the formula

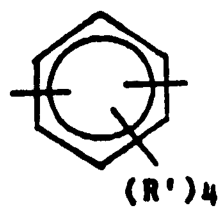

each R is independently hydrogen or an alkyl group having from 1 to 4 carbon atoms; each Q is independently hydrogen or a hydrocarbyl group having from 1 to 10 carbon atoms; each R′ is independently hydrogen, a hydrocarbyl or hydrocarbyloxy group having from 1 to 10 carbon atoms or a halogen; m has a value of n-1; m′ has a value of n′-1; m″ has a value of n″-1 whereby each of m, m′ and m″ has at least the value zero; each n, n′ and n″ independently has a value from zero to 3; q has a value from zero to 4; each y independently has an average value from 1 to 5; y′ has an average value of from zero to 3 and each z and z′ independently has a value from zero to 3;

(2) the reaction product of

(a) at least one epoxy resin as defined in component (A-1) and

b) at least one dihydric or polyhydric phenol represented by the following formulas VII, VIII or IX

FORMULA VII

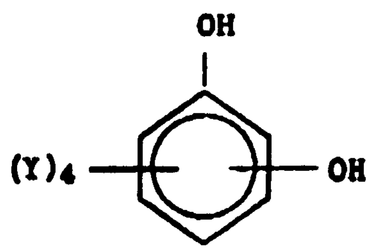

FORMULA VIII

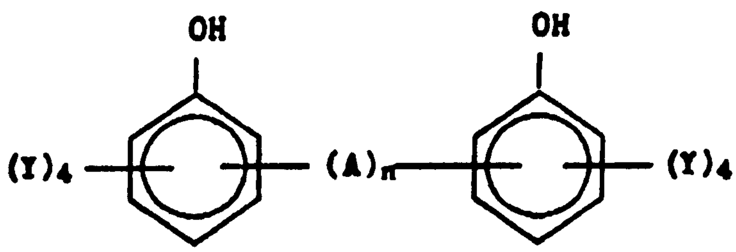

FORMULA (IX)

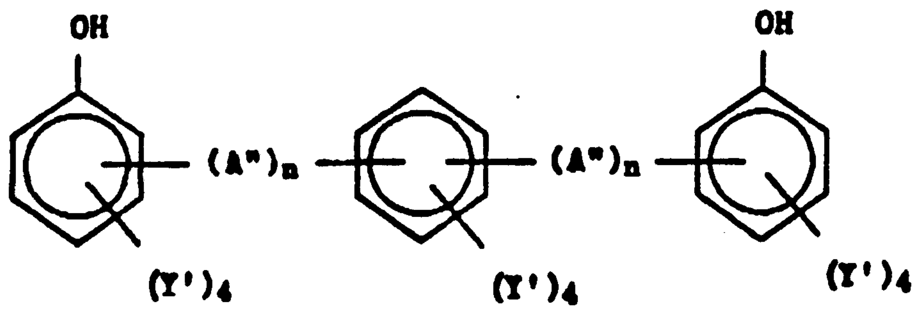

wherein A is a divalent hydrocarbon group having from 1 to 12 carbon atoms, -O-, -S-, -S-S-, -SO-, $-SO_2-$, or -CO-; each Y is independently hydrogen, a halogen or a hydrocarbyl or hydrocarbyloxy group having from 1 to 10 carbon atoms; each A″ is independently a divalent hydrocarbon group having from 1 to 6 carbon atoms; each Y′ is independently hydrogen, a hydrocarbyl or hydrocarbyloxy group having from 1 to 10, preferably from 1 to 4 carbon atoms, a halogen atom or a hydroxyl group; and n has a value of 0 or 1; and wherein components (A-2-a) and (A-2-b) are present in quantities such that the ratio of phenolic hydroxyl groups to epoxide groups is from 0.01:1 to 0.5:1; or

(3) mixtures thereof; and

(B) at least one halogenated dihydric phenol represented by the following formulas X, XI or XII

FORMULA X

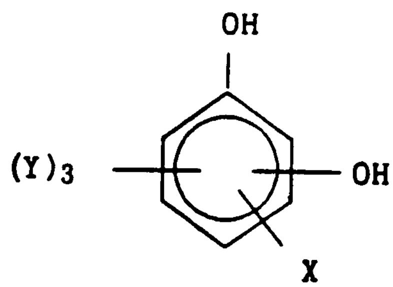

FORMULA XI

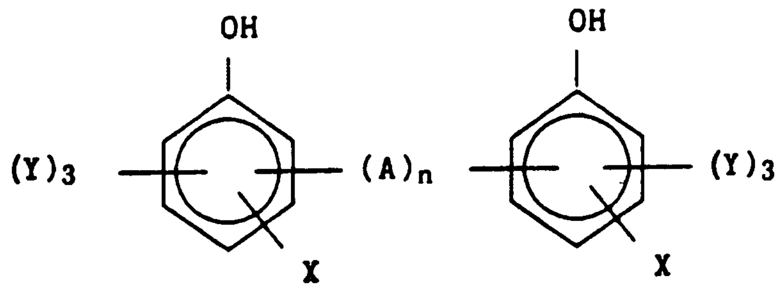

FORMULA XII

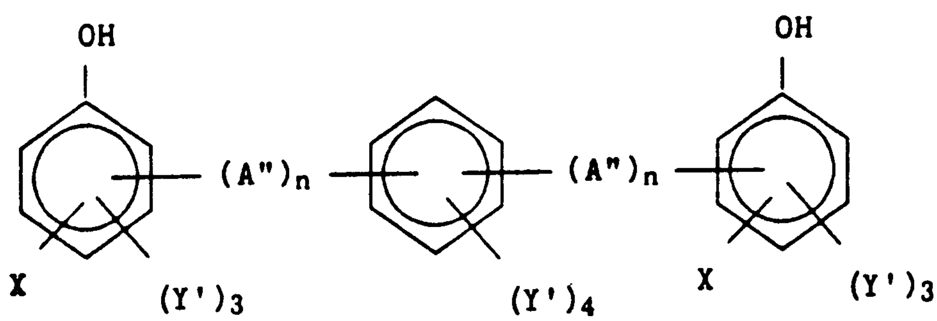

wherein A, A″, Y, Y′ and n are as defined above; each X is a halogen; by mixing components (A) and (B) in quantities such that the ratio of phenolic hydroxyl groups to epoxide groups is from 0.7:1 to 1.1 :1 said method being characterized by employing as at least a portion of component (B) a halogenated dihydric phenol wherein at least 5 weight percent of the halogen atoms present in component (B) are in the meta position with respect to the hydroxyl groups.

**2.** A composition of Claim 1 wherein components (A) and (B) are mixed in quantities such that the ratio of phenolic hydroxyl groups to epoxide groups is from 0.85:1 to 1:1; and a stabilizing quantity of a stabilizer represented by the formula

FORMULA XV.

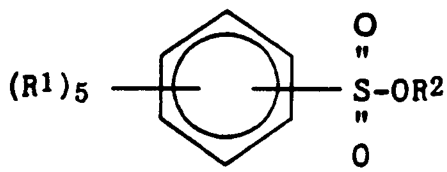

wherein each $R^1$ is independently hydrogen, a hydrocarbyl group having from 1 to 10 carbon atoms or a halogen, and $R^2$ is a hydrocarbyl group having from 1 to 10 carbon atoms is present; characterized in that at least 30 weight percent of the halogen atoms present in component (B) are in the meta position with respect to the hydroxyl groups.

**3.** A method according to Claim 2 wherein components (A) and (B) are mixed in quantities such that the ratio of phenolic hydroxyl groups to epoxide groups is from 0.9:1 to 0.95:1; and said stabilizer is present in an amount of from 0.001 to 10 percent by weight of the weight of component (A); characterized in that at least 50 weight percent of the halogen atoms present in component (B) are in the meta position with respect to the hydroxyl groups.

**4.** A method according to anyone of Claims 1 to 3 wherein component (A) is component (A-1) represented by formula I or II wherein Q, R and R′ are hydrogen; q has an average value of from 0.1 to 2 and component (B) is represented by formula XI wherein A is a divalent hydrocarbyl group having from 1 to 6 carbon atoms, and each X is bromine.

**5.** A method according to anyone of Claims 1 to 3 wherein component (A) is component (A-1) represented by formula III wherein A′ has from 1 to 4 carbon atoms and each R and R′ is hydrogen and component (B) is represented by formula XI wherein A is a divalent hydrocarbyl group having from 1 to 6 carbon atoms and each X is bromine.

**6.** A method according to anyone of Claims 1 to 3 wherein component (A) is component (A-1) represented by formulas IV or V wherein each Q, R and R′ is hydrogen and component (B) is represented by formula XI wherein A is a divalent hydrocarbyl group having from 1 to 6 carbon atoms and each X is bromine.

**7.** A method according to anyone of Claims 1 to 3 wherein component (A) is component (A-1) represented by formula VI wherein each Q and R′ is hydrogen and component (B) is represented by formula XI wherein A is a divalent hydrocarbyl group having from 1 to 6 carbon atoms and each X is bromine.

**8.** A method according to anyone of Claims 4-7 wherein component (B) is 2,2′,6,6′-tetrabromo-3,3′,5,5′-tetramethyl-4,4′-biphenol or 2,2′,6-tribromo-3,3′,5,5′-tetra-methyl-4,4′-biphenol or 4,4′-methylene-bis-3,5-dibromo- -2,6-dimethylphenol, or mixture thereof and said stabilizer is methyl p-toluene sulfonate.

**9.** A method for preparing a composition which method comprises mixing (I) a composition of any one of Claims 1-8 and (II) a catalytic quantity of at least one catalyst for effecting the reaction between components (I-A) and (I-B).

**10.** An method for preparing an electrical laminate the method comprising impregnating on or more layers of a substrate with a composition of Claim 9.

## Revendications

### Revendications pour les Etats contractants suivants : BE, CH, DE, FR, GB, IT, LI, NL, SE

**1.** Composition comprenant

(A) au moins l'un parmi

(1) au moins une résine époxy représentée par l'une des formules I, II, III, IV, V ou VI

FORMULE I

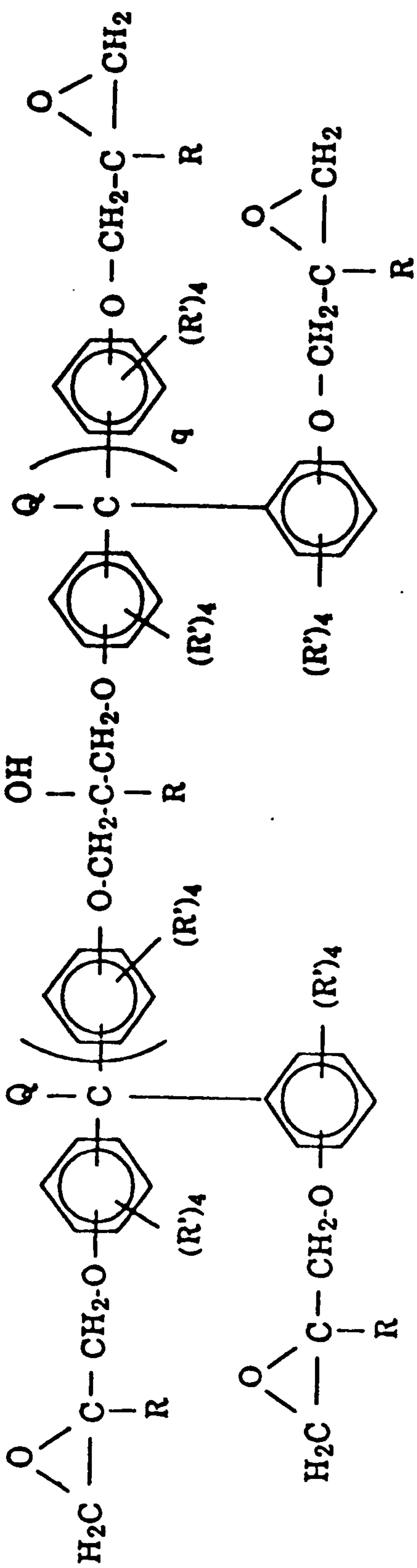

FORMULE II

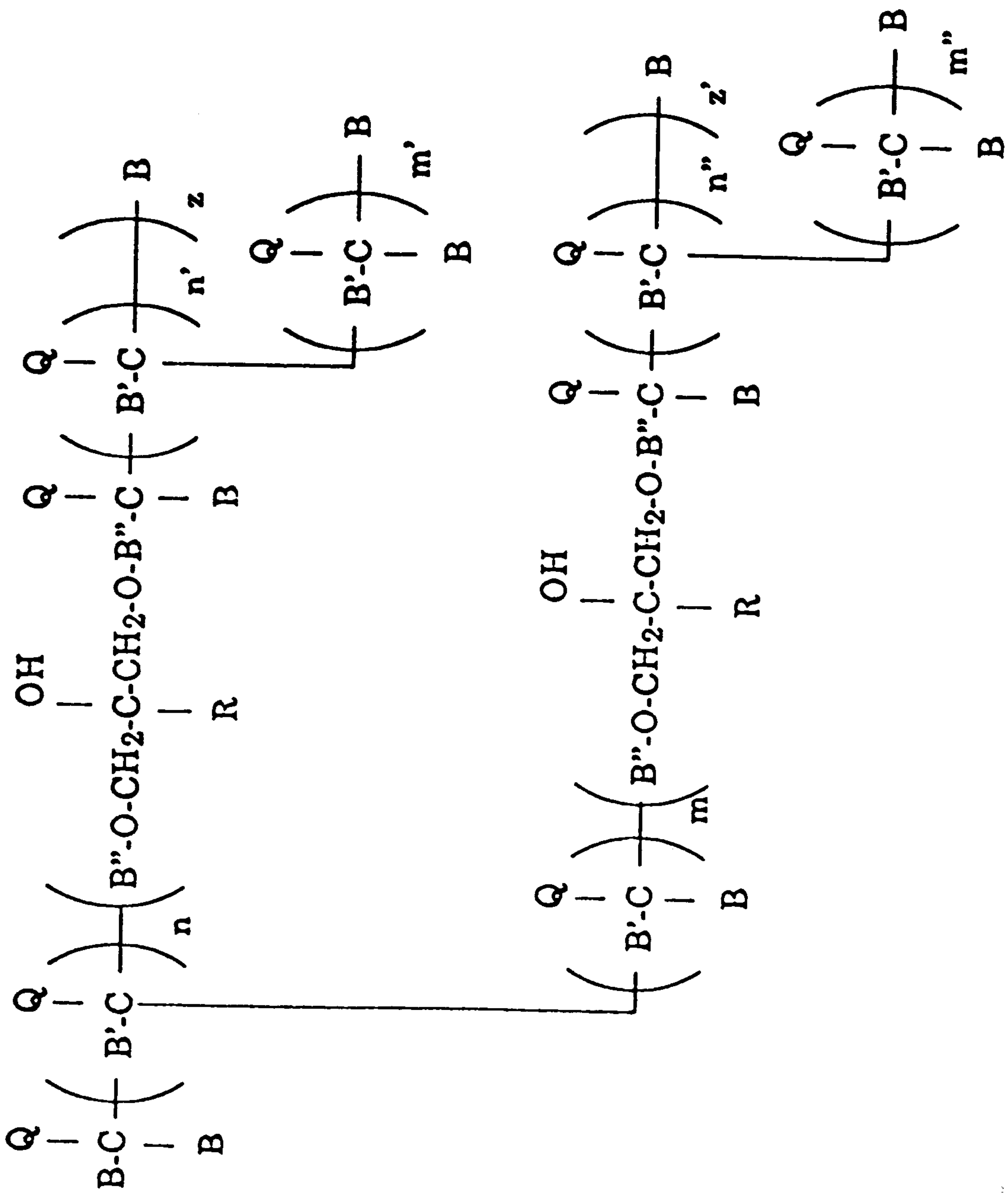

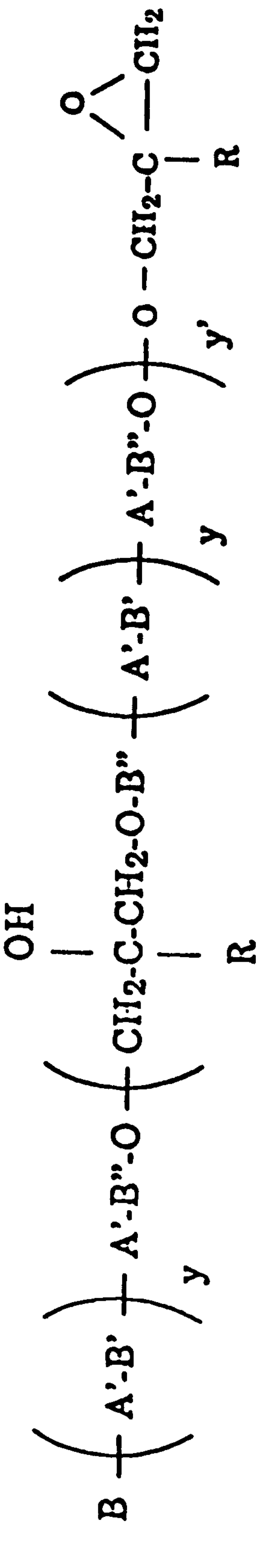

FORMULE III

FORMULE IV

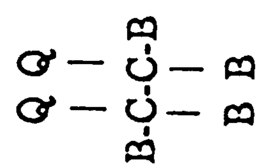

FORMULE V

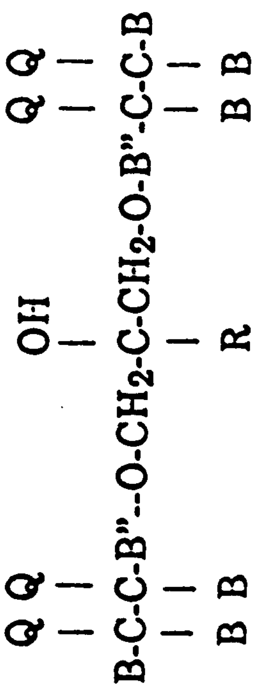

FORMULE VI

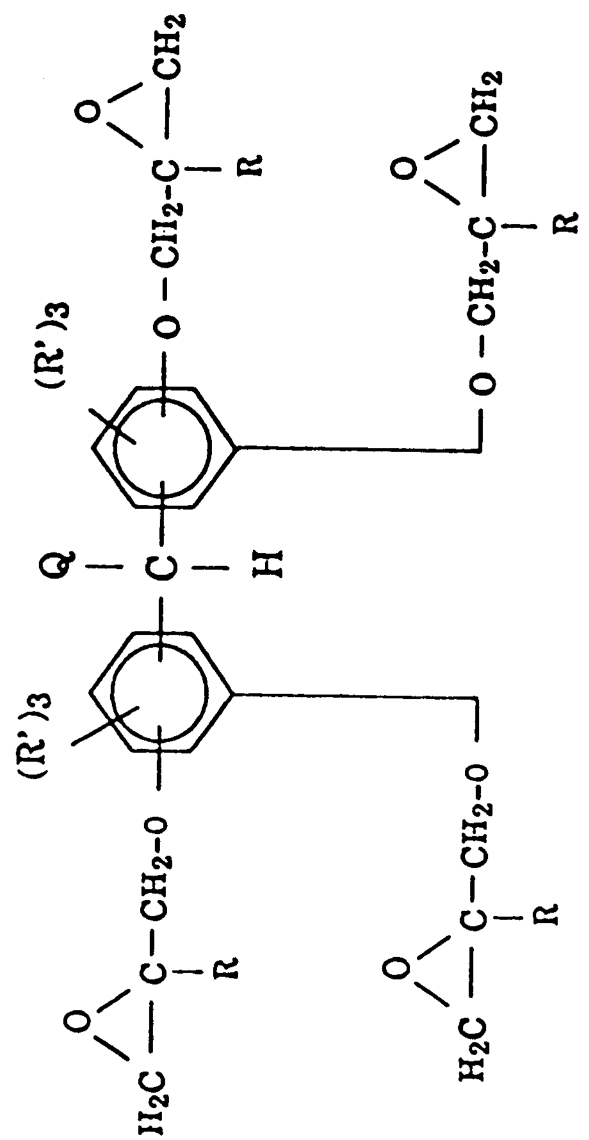

dans lesquelles chaque A' est indépendamment un groupe hydrocarbyle divalent comprenant de 1 à 12 atomes de carbone, -S-, -SS-, -SO-, $-SO_2-$, -CO-, ou -O-;

chaque B est représenté par la formule

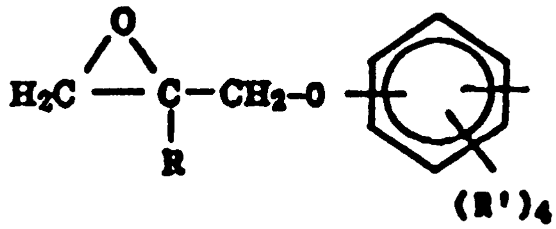

chaque B' est représenté par la formule

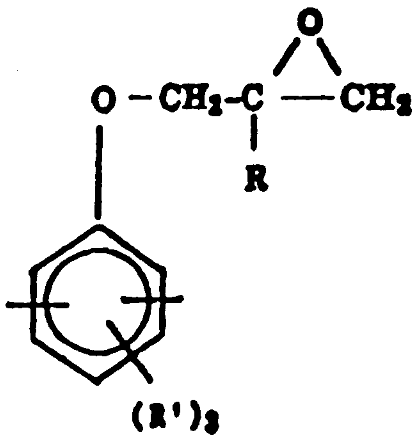

chaque B" est représenté par la formule

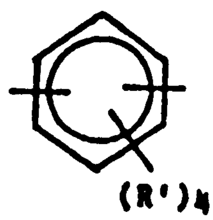

chaque R est indépendamment l'hydrogène ou un groupe alkyle comprenant de 1 à 4 atomes de carbone; chaque Q est indépendamment l'hydrogène ou un groupe hydrocarbyle comportant de 1 à 10 atomes de carbone; chaque R' est indépendamment l'hydrogène, un groupe hydrocarbyle ou hydrocarbyloxy comportant de 1 à 10 atomes de carbone ou un halogène; la valeur de m est n-1; celle de m' est n'-1; celle de m" est n"-1, les valeurs de m, m' et m" sont chacune égales au moins à zéro; les valeurs de n, n' et n" sont indépendamment comprises chacune entre zéro et 3; la valeur de q est comprise entre zéro et 4; lavaleur moyenne de chaque y est comprise indépendamment entre 1 et 5; la valeur moyenne de y' est comprise entre zéro et 3 et les valeurs de z et z' sont indépendamment comprises chacune entre zéro et 3 ;

(2) le produit de réaction de

(a) au moins une résine époxy telle que définie dans le composant (A-1) et

(b) au moins un diphénol ou un polyphénol représenté par les formules VII, VIII ou IX

FORMULE VII

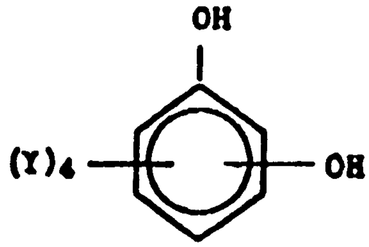

FORMULE VIII

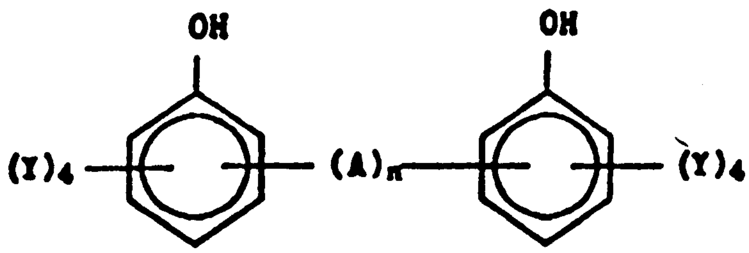

FORMULE IX

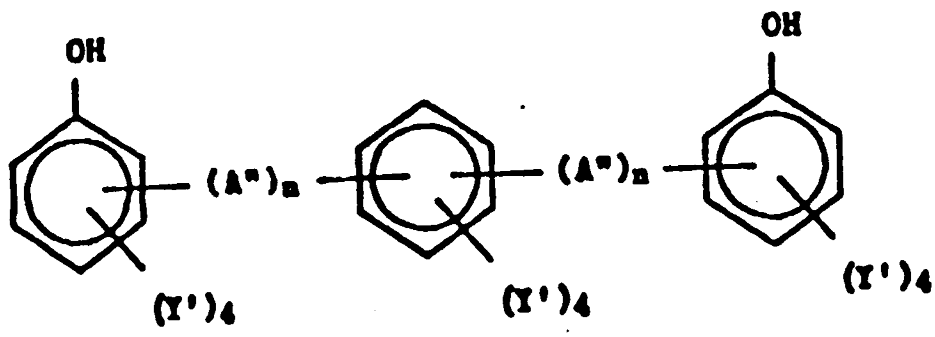

où A est un groupe hydrocarbure divalent comprenant de 1 à 12 atomes de carbone, -O-, -S-, -S-S-, -SO-, $-SO_2-$, ou -CO-; chaque Y est indépendamment l'hydrogène, un halogène ou un groupe hydrocarbyle ou hydrocarbyloxy comportant de 1 à 10 atomes de carbone; chaque A" est indépendamment un groupe hydrocarbure divalent comportant de 1 à 6 atomes de carbone; chaque Y' est indépendamment l'hydrogène, un groupe hydrocarbyle ou hydrocarbyloxy comportant de 1 à 10, de préférence de 1 à 4 atomes de carbone, un atome d'halogène ou un groupe hydroxyle; et la valeur de n est comprise entre 0 ou 1; et où les composants (A-2-a) et (A-2-b) sont présents en quantités telles que le rapport entre les groupes hydroxyle phénoliques et les groupes époxyde est compris entre 0,01:1 et 0,5:1; ou
(3) des mélanges de ceux-ci; et

(B) au moins un diphénol halogéné représenté par les formules suivantes X, XI ou XII

FORMULE X

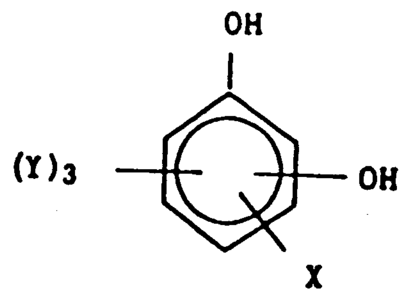

FORMULE XI

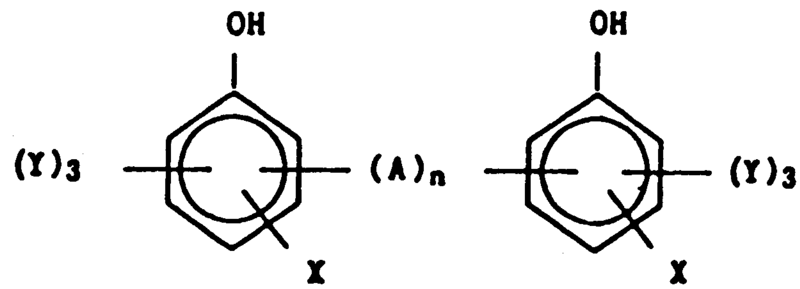

FORMULE XII

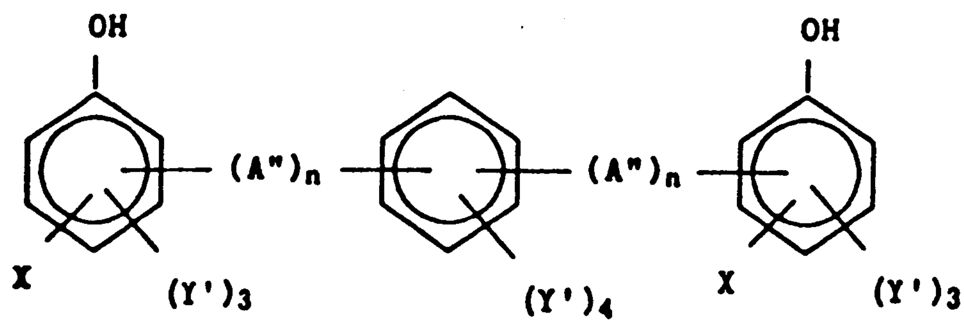

dans lesquelles les composants (A) et (B) sont présents en quantités telles que le rapport entre les groupes hydroxyle phénoliques et les groupes époxyde est compris entre 0,7:1 et 1,1:1; caractérisée par l'emploi, en tant qu'une partie au moins du composant (B), d'un diphénol halogéné dans lequel au moins 5 pour-cent en poids des atomes d'halogène présents dans le composant (B) sont en position méta par rapport aux groupes hydroxyle.

**2.** Composition selon la revendication 1 dans laquelle les composants (A) et (B) sont présents en quantités telles que le rapport entre les groupes hydroxyle phénoliques et les groupes époxyde est compris entre 0,85:1 et 1:1; et dans laquelle est présente une quantité stabilisante d'un stabilisateur représentée par la formule

FORMULE XV

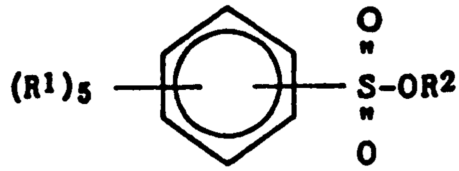

dans laquelle chaque $R^1$ est indépendamment l'hydrogène, un groupe hydrocarbyle comportant de 1 à 10 atomes de carbone ou un halogène, et $R^2$ est un groupe hydrocarbyle comportant de 1 à 10 atomes de carbone; caractérisée en ce qu'au moins 30 pour-cent en poids des atomes d'halogène présents dans le composant (B) sont en position méta par rapport aux groupes hydroxyle.

**3.** Composition selon la revendication 2 dans laquelle les composants (A) et (B) sont présents en quantités telles que le rapport entre les groupes hydroxyle phénoliques et les groupes époxy est compris entre 0,9:1 et 0.95:1; et ledit stabilisateur est présent en quantité comprises entre 0,001 et 10 pour-cent en poids du poids du composant (A); caractérisée en ce qu'au moins 50 pour-cent en poids des atomes d'halogène présents dans le composant (B) sont en position méta par rapport aux groupes hydroxyle.

**4.** Composition selon la revendication 1 ou la revendication 2 dans laquelle le composant (A) est le composant (A-1) représenté par la formule I ou II dans lesquelles Q, R et R' sont l'hydrogène; q a une valeur moyenne comprise entre 0,1 et 2 et le composant (B) est représenté par la formule XI où A est un groupe hydrocarbyle divalent comportant de 1 à 6 atomes de carbone, et chaque X est le brome.

**5.** Composition selon la revendication 1 ou la revendication 2 dans laquelle le composant (A) est le composant (A-1) représenté par la formule III dans laquelle A' comprend de 1 à 4 atomes de carbone et chaque R et R' est l'hydrogène, et le composant (B) est représenté par la formule XI où A est un groupe hydrocarbyle divalent comportant de 1 à 6 atomes de carbone et chaque X est le brome.

**6.** Composition selon la revendication 1 ou la revendication 2 dans laquelle le composant (A) est le composant (A-1) représenté par les formules IV ou V dans lesquelles chaque Q, R et R' est l'hydrogène et le composant (B) est représenté par la formule XI dans laquelle A est un groupe hydrocarbyle divalent comportant de 1 à 6 atomes de carbone et chaque X est le brome.

**7.** Composition selon la revendication 1 ou la revendication 2 dans laquelle le composant (A) est le composant (A-1) représenté par la formule VI dans laquelle chaque Q et R' est l'hydrogène et le composant (B) est représenté par la formule XI dans laquelle A est un groupe hydrocarbyle divalent comportant de 1 à 6 atomes de carbone et chaque X est le brome.

**8.** Composition selon l'une quelconque des revendications 4 à 7 dans laquelle le composant (B) est le 2,2',6,6'-tétrabromo-3,3',5,5'-tétraméthyl-4,4'-biphénol ou le 2,2',6-tribromo-3,3',5,5'-tétra-méthyl-4,4'-biphénol ou le 4,4'-méthylène-bis-3,5-dibromo-2,6-diméthylphénol, ou un mélange de ceux-ci et ledit stabilisateur est le p-toluène-sulfonate de méthyle.

**9.** Composition qui comprend (I) une composition selon l'une quelconque des revendications 1 à 8 et (II) une quantité catalytique d'au moins un catalyseur destiné à effectuer la réaction entre les composants (I-A) et (I-B).

**10.** Un laminé électrique préparé à partir d'une ou plusieurs couches d'un substrat imprégné d'une composition selon la revendication 9.

**Revendications pour les Etats contractants suivants : AT, ES**

**1.** Procédé de préparation d'une composition, ladite composition comprenant
(A) au moins l'un parmi

(1) au moins une résine époxy représentée par l'une des formules I, II, III, IV, V ou VI

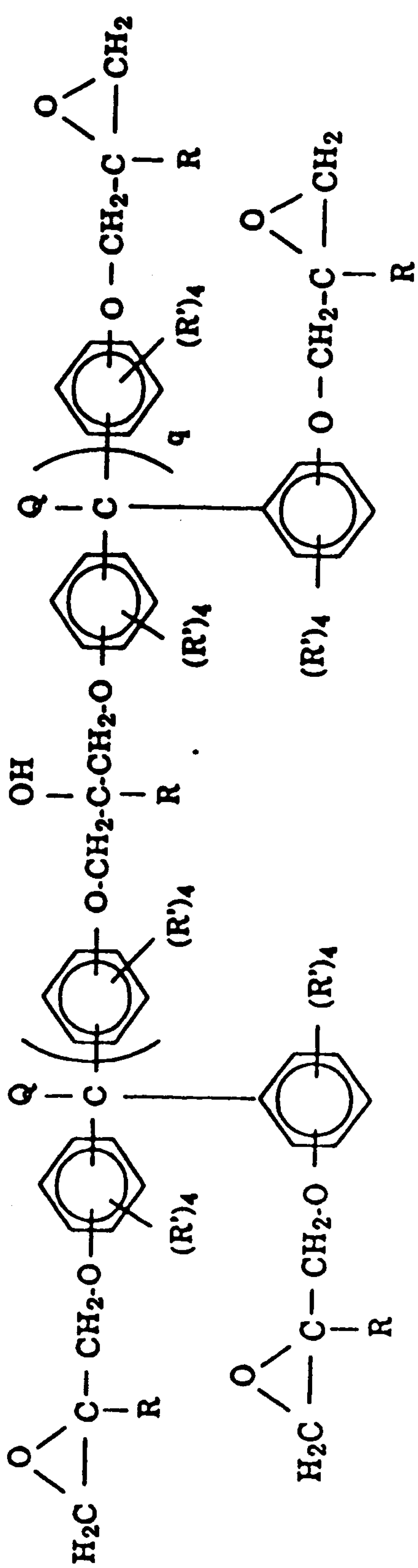

FORMULE I

FORMULE II

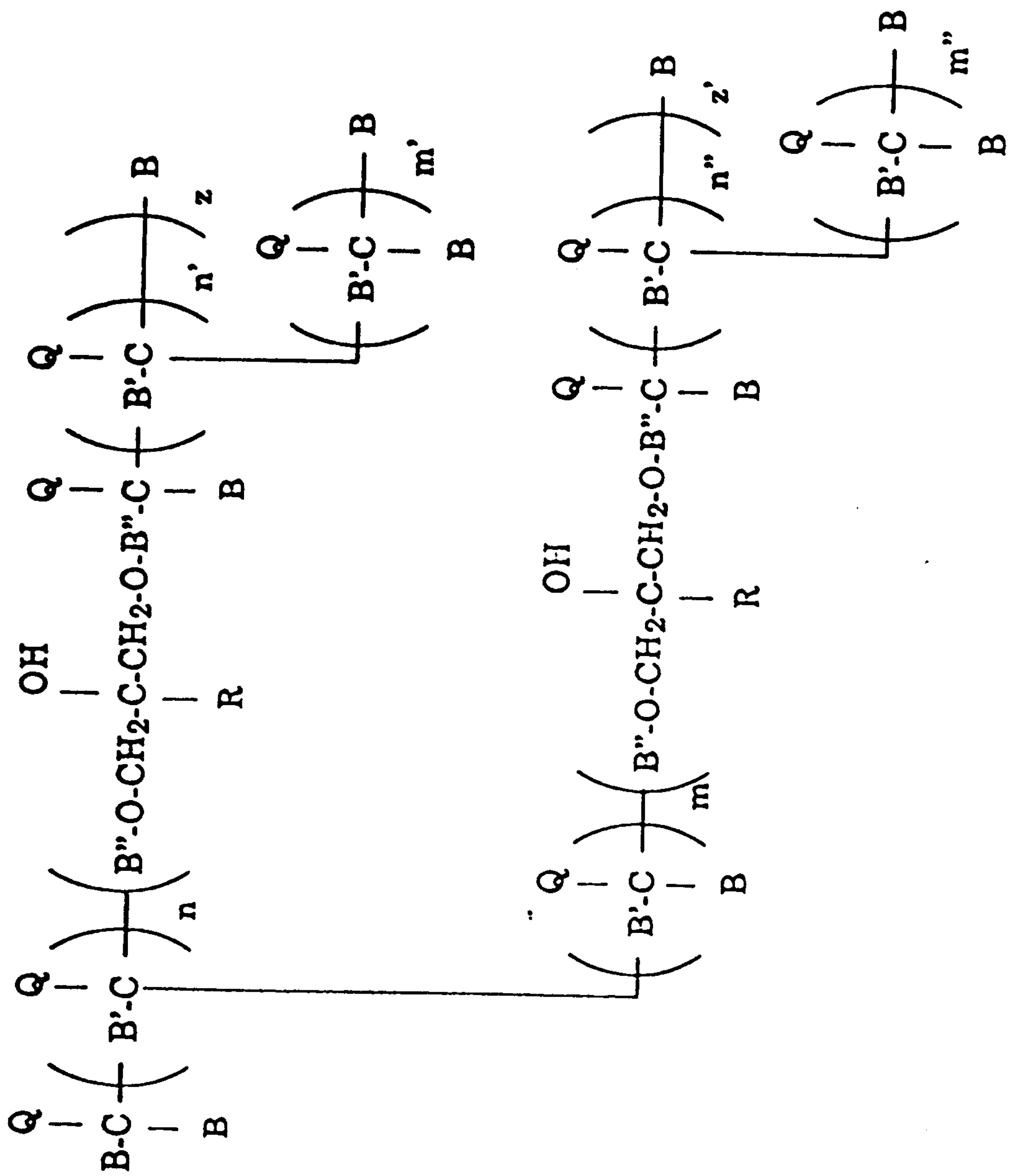

FORMULE III

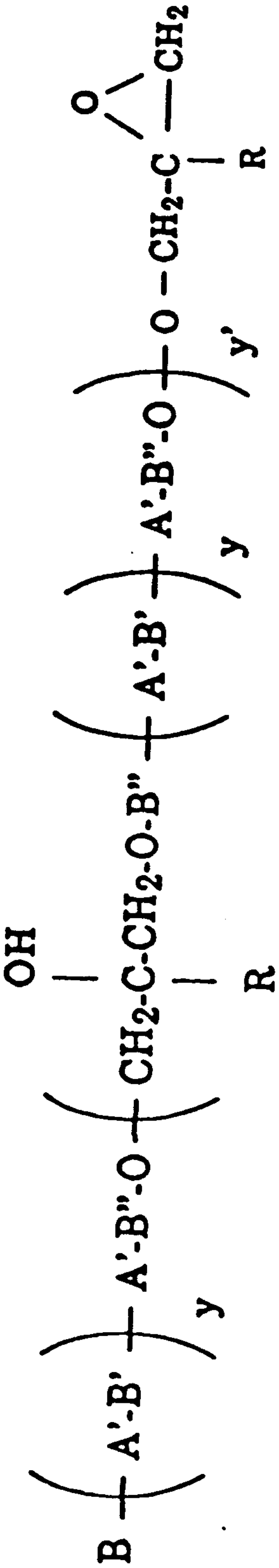

FORMULE IV

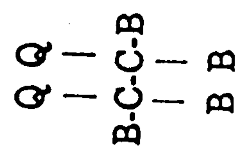

FORMULE V

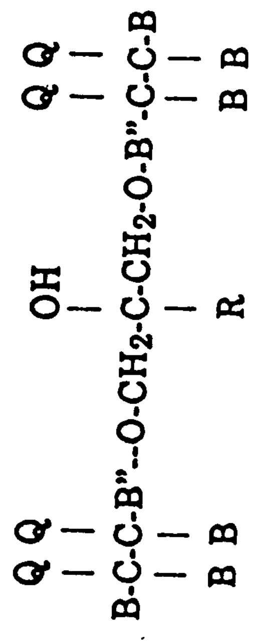

FORMULE VI

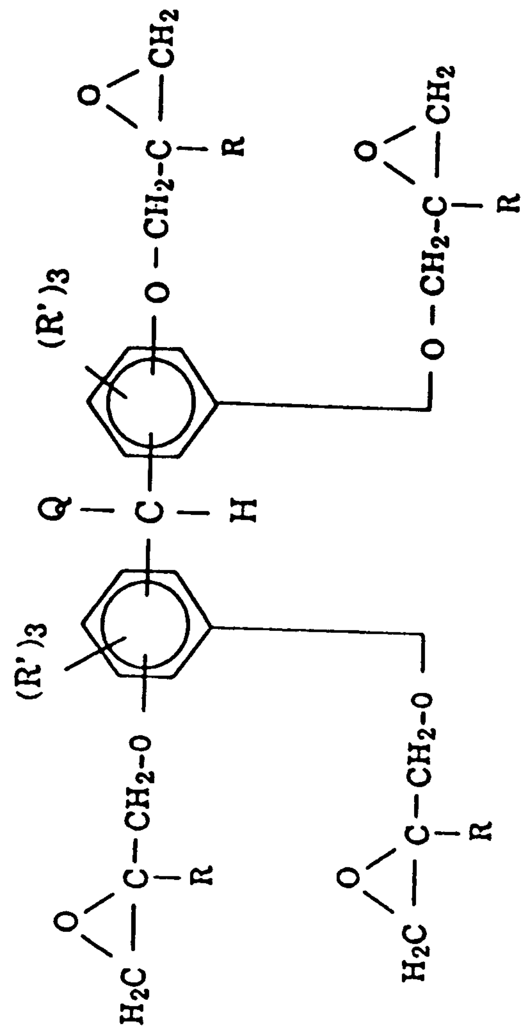

dans lesquelles chaque A' est indépendamment un groupe hydrocarbyle divalent comprenant de 1 à 12 atomes de carbone, -S-, -SS-, -SO-. $-SO_2-$, -CO-, ou -O-;

chaque B est représenté par la formule

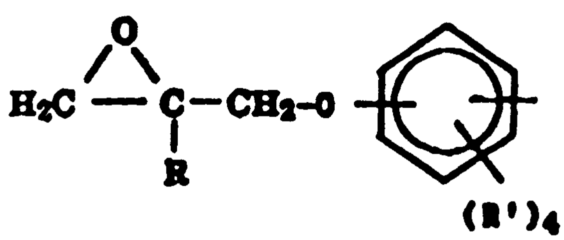

chaque B' est représenté par la formule

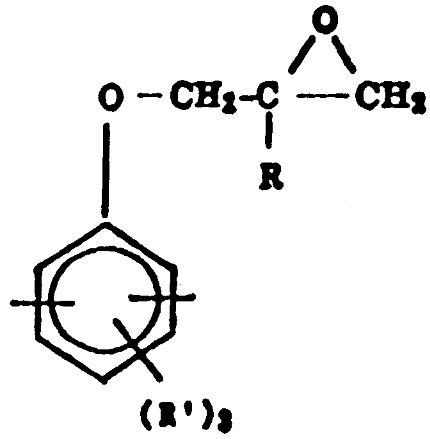

chaque B" est représenté par la formule

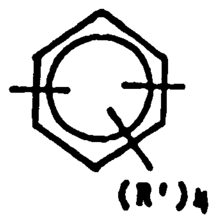

chaque R est indépendamment l'hydrogène ou un groupe alkyle comprenant de 1 à 4 atomes de carbone; chaque Q est indépendamment l'hydrogène ou un groupe hydrocarbyle comportant de 1 à 10 atomes de carbone; chaque R' est indépendamment l'hydrogène, un groupe hydrocarbyle ou hydrocarbyloxy comportant de 1 à 10 atomes de carbone ou un halogène; la valeur de m est n-1: celle de m' est n'-1; celle de m" est n"-1, les valeurs de m, m' et m" sont chacune égales au moins à zéro; les valeurs de n, n' et n" sont indépendamment comprises chacune entre zéro et 3; la valeur de q est comprise entre zéro et 4; lavaleur moyenne de chaque y est comprise indépendamment entre 7 et 5; la valeur moyenne de y' est comprise entre zéro et 3 et les valeurs de z et z' sont indépendamment comprises chacune entre zéro et 3 ;

(2) le produit de réaction de

(a) au moins une résine époxy telle que définie dans le composant (A-1) et

(b) au moins un diphénol ou un polyphénol représenté par les formules VII, VIII ou IX

FORMULE VII

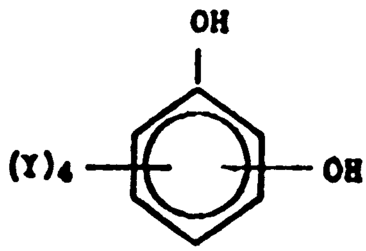

FORMULE VIII

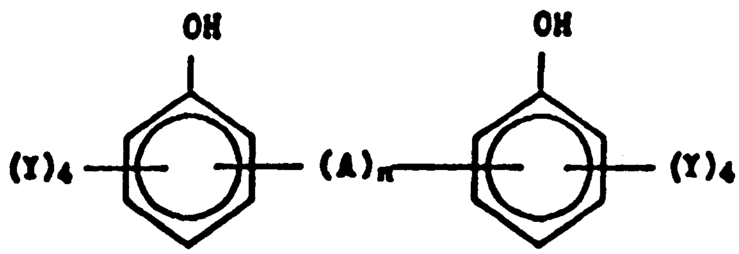

FORMULE IX

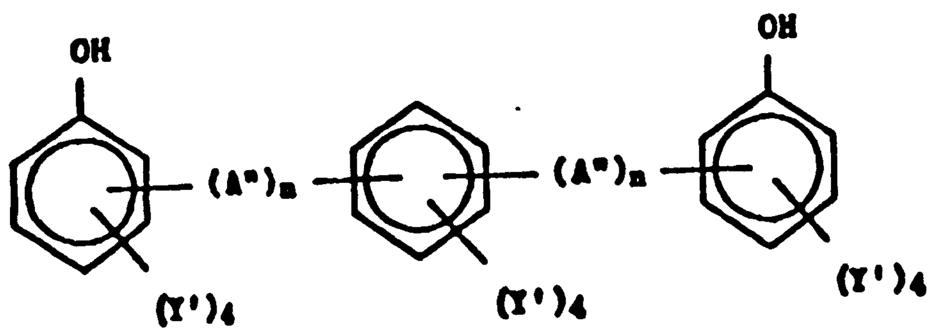

où A est un groupe hydrocarbure divalent comprenant de 1 à 12 atomes de carbone, -O-, -S-, -S-S-, -SO-, $-SO_2-$, ou -CO-: chaque Y est indépendamment l'hydrogène, un halogène ou un groupe hydrocarbyle ou hydrocarbyloxy comportant de 1 à 10 atomes de carbone; chaque A" est indépendamment un groupe hydrocarbure divalent comportant de 1 à 6 atomes de carbone; chaque Y' est indépendamment l'hydrogène, un groupe hydrocarbyle ou hydrocarbyloxy comportant de 1 à 10, de préférence de 1 à 4 atomes de carbone, un atome d'halogène ou un groupe hydroxyle; et la valeur de n est comprise entre 0 ou 1; et où les composants (A-2-a) et (A-2-b) sont présents en quantités telles que le rapport entre les groupes hydroxyle phénoliques et les groupes époxyde est conpris entre 0.01:1 et 0,5:1; ou

(3) des mélanges de ceux-ci; et

(B) au moins un diphénol halogéné représenté par les formules suivantes X, XI ou XII

FORMULE X

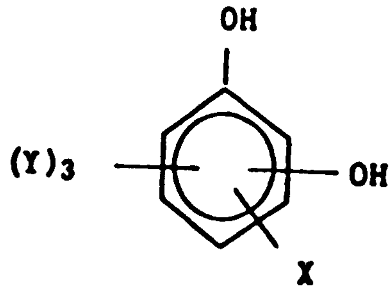

FORMULE XI

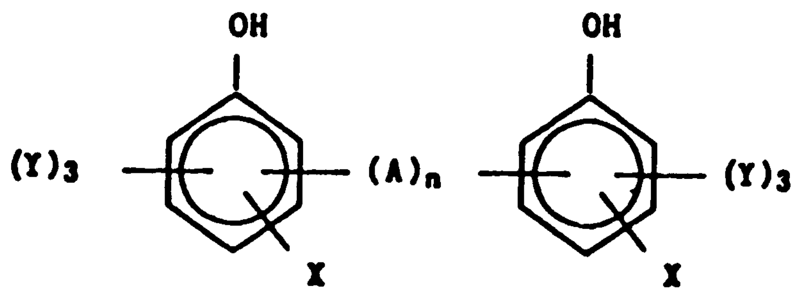

FORMULE XII

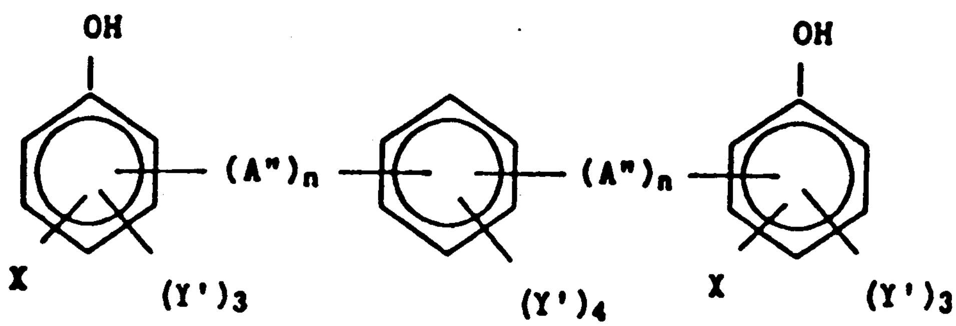

dans lesquelles

chaque A, A", Y, Y' sont tels que définis plus haut; chaque X est un halogène; en mélangeant les composants (A) et (B) en quantités telles que le rapport entre les groupes hydroxyle phénoliques et les groupes époxyde est compris entre 0.7:1 et 1,1:1; ledit procédé étant caractérisé par l'emploi, en tant qu'une partie au moins du composant (B), d'un diphénol halogéné dans lequel au moins 5 pour-cent en poids des atomes d'halogène présents dans le composant (B) sont en position méta par rapport aux groupes hydroxyle.

**2.** Procédé selon la revendication 1 dans laquelle les composants (A) et (B) sont mélangés en quantités telles que le rapport entre les groupes hydroxyle phénoliques et les groupes époxyde est compris entre 0,85:1 et 1:1; et on mélange une quantité stabilisante d'un stabilisateur représentée par la formule

FORMULE XV

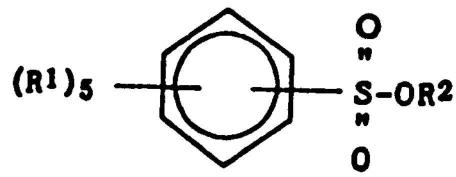

dans laquelle chaque $R^1$ est indépendamment l'hydrogène, un groupe hydrocarbyle comportant de 1 à 10 atomes de carbone ou un halogène, et $R^2$ est un groupe hydrocarbyle comportant de 1 à 10 atomes de carbone; caractérisé en ce qu'au moins 30 pour-cent en poids des atomes d'halogène présents dans le composant (B) sont en position méta par rapport aux groupes hydroxyle.

**3.** Procédé selon la revendication 2 dans laquelle les composants (A) et (B) sont mélangés en quantités telles que le rapport entre les groupes hydroxyle phénoliques et les groupes époxyde est compris entre 0,9:1 et 0,95:1; et ledit stabilisateur est présent en quantité comprises entre 0,001 et 10 pour-cent en poids du poids du composant (A); caractérisé en ce qu'au moins 50 pour-cent en poids des atomes d'halogène présents dans le conposant (B) sont en position méta par rapport aux groupes hydroxyle.

**4.** Procédé selon l'une quelconque des revendications 1 à 3 dans lequel le composant (A) est le composant (A-1) représenté par la formule I ou II dans lesquelles Q, R et R' sont l'hydrogène; q a une valeur moyenne comprise entre 0,1 et 2 et le composant (B) est représenté par la formule XI où A est un groupe hydrocarbyle divalent comportant de 1 à 6 atomes de carbone, et chaque X est le brome.

**5.** Procédé selon l'une quelconque des revendications 1 à 3 dans lequel le composant (A) est le composant (A-1) représenté par la formule III dans laquelle A' comprend de 1 à 4 atomes de carbone et chaque R et R' est l'hydrogène, et le composant (B) est représenté par la formule XI où A est un groupe hydrocarbyle divalent comportant de 1 à 6 atomes de carbone et chaque X est le brome.

**6.** Procédé selon l'une quelconque des revendications 1 à 3 dans lequel le composant (A) est le composant (A-1) représenté par les formules IV ou V dans lesquelles chaque Q, R et R' est l'hydrogène et le composant (B) est représenté par la formule XI dans laquelle A est un Groupe hydrocarbyle divalent comportant de 1 à 6 atomes de carbone et chaque X est le brome.

**7.** Procédé selon l'une quelconque des revendications 1 à 3 dans lequel le composant (A) est le composant (A-1) représenté par la formule VI dans laquelle chaque Q et R' est l'hydrogène et le composant (B) est représenté par la formule XI dans laquelle A est un groupe hydrocarbyle divalent comportant de 1 à 6 atomes de carbone et chaque X est le brome.

**8.** Procédé selon l'une quelconque des revendications 4 à 7 dans laquelle le composant (B) est le 2,2',6,6'-tétrabromo-3,3',5,5'-tétraméthyl-4,4'-biphénol ou le 2,2',6-tribromo-3,3',5,5'-tétra-méthyl-4,4'-biphénol ou le 4,4'-méthylène-bis-3,5-dibromo-2,6-diméthylphénol, ou un mélange de ceux-ci et ledit stabilisateur est le p-toluène-sulfonate de méthyle.

**9.** Procédé de préparation d'une composition, ledit procédé consistant à mélanger (I) une composition selon l'une quelconque des revendications 1 à 8 et (II) une quantité catalytique d'au moins un catalyseur destiné à effectuer la réaction entre les composants (I-A) et (I-B).

**10.** Procédé de préparation d'un laminé électrique consistant à imprégner une ou plusieurs couches d'un substrat à l'aide d'une composition selon la revendication 9.

## Patentansprüche

**Patentansprüche für folgende Vertragsstaaten : BE, CH, DE, FR, GB, IT, LI, NL, SE**

**1.** Zusammensetzung, umfassend:

(A) wenigstens einen Bestandteil von:

(1) wenigstens einem Epoxyharz, wiedergegeben durch die folgenden Formeln I, II, III, IV, V oder VI

FORMEL I

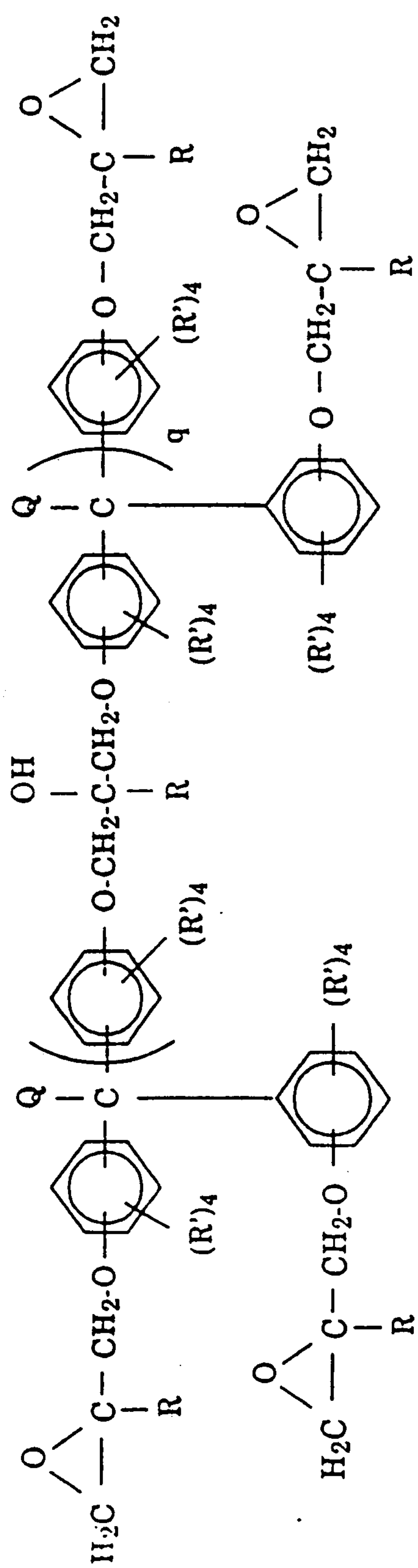

FORMULE II

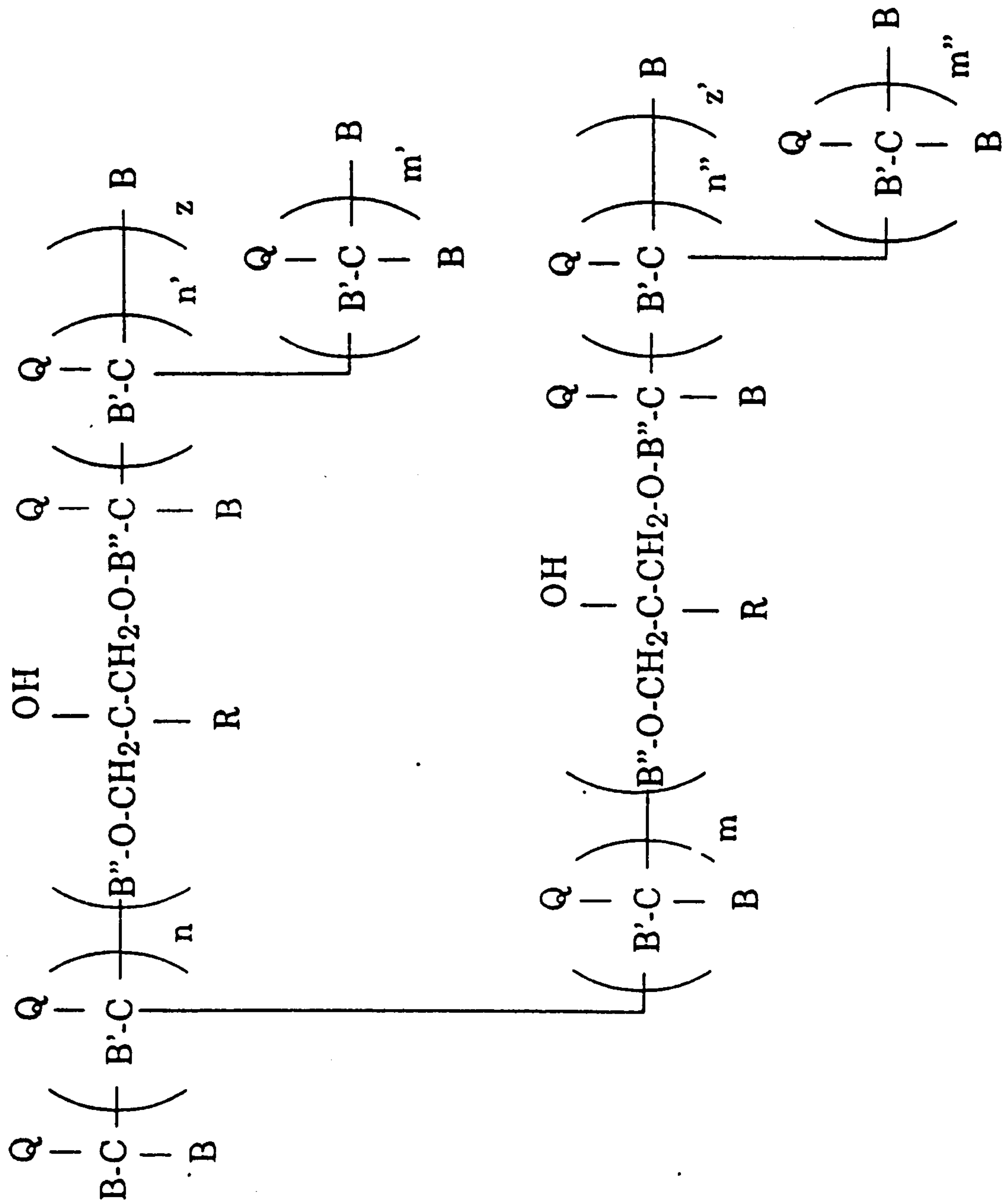

FORMEL III

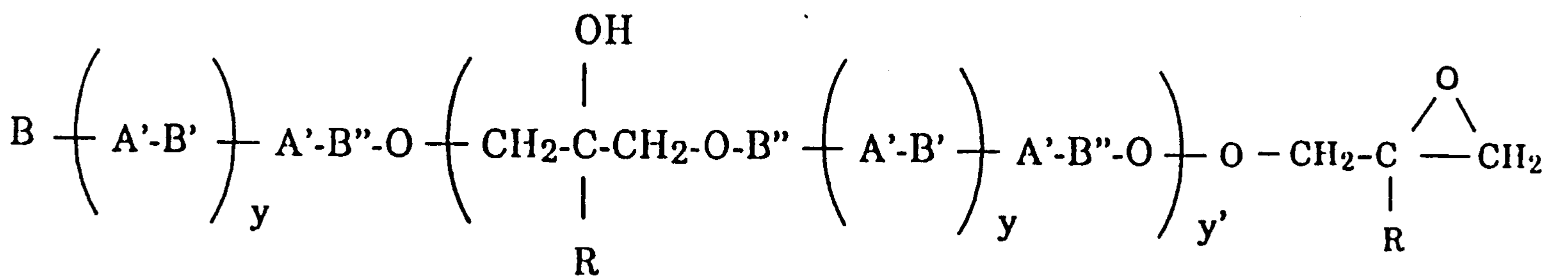

FORMEL IV

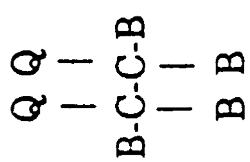

FORMEL V

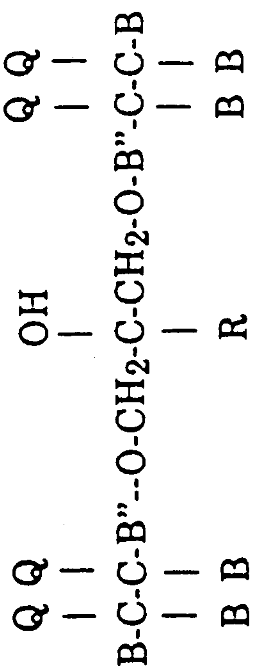

FORMEL VI

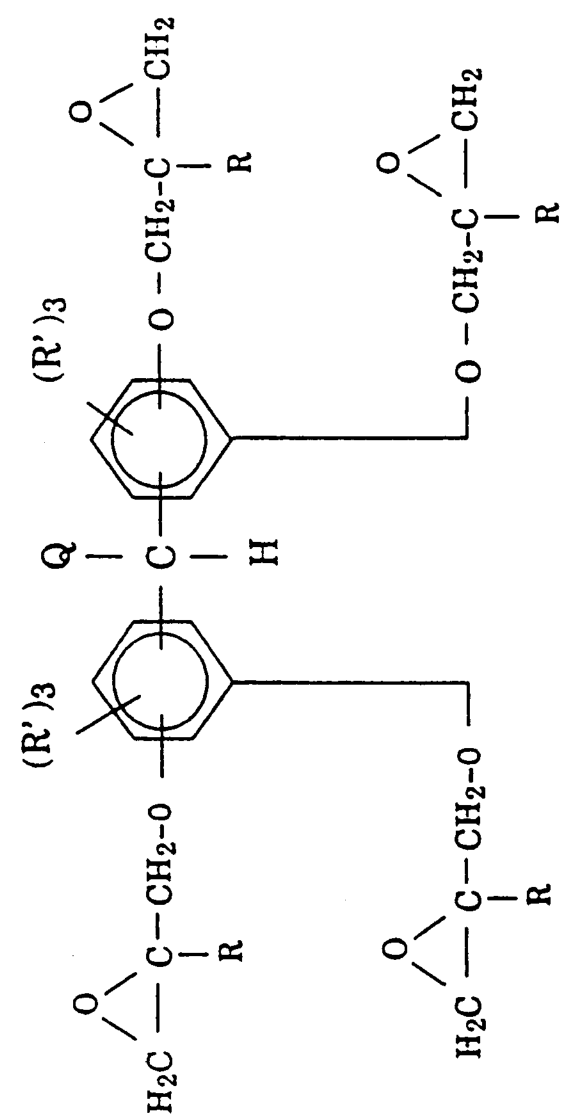

worin jedes A' unabhängig voneinander ein zweiwertiger Kohlenwasserstoffrest mit 1 bis 12 Kohlenstoffatomen, -S-, -S-S-, -SO-, $-SO_2-$, -CO- oder -O- ist;
jedes B durch die Formel:

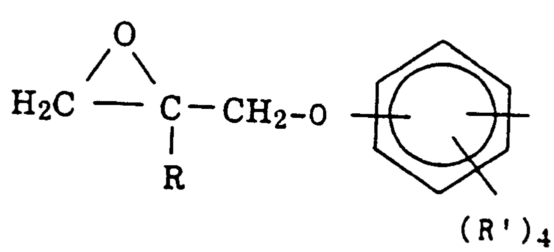

wiedergegeben wird,
jedes B' durch die Formel:

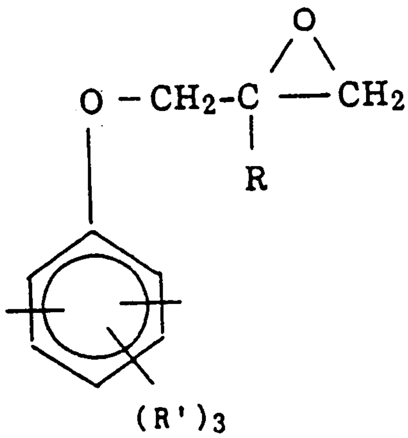

wiedergegeben wird,
jedes B" durch die Formel:

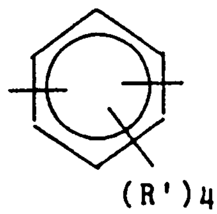

wiedergegeben wird,
jedes R unabhängig voneinander Wasserstoff oder ein Alkylrest mit 1 bis 4 Kohlenstoffatomen ist; jedes Q unabhängig voneinander Wasserstoff oder ein Kohlenwasserstoffrest mit 1 bis 10 Kohlenstoffatomen ist; jedes R' unabhängig voneinander Wasserstoff, ein Kohlenwasserstoff- oder Kohlenwasserstoffoxy-rest mit 1 bis 10 Kohlenstoffatomen oder ein Halogen ist; m einen Wert von n-1 hat; m' einen Wert von n'-1 hat; m" einen Wert von n"-1 hat, wobei jedes m, m' und m" wenigstens den Wert null besitzt; jedes n, n' und n" unabhängig voneinander einen Wert von 0 bis 3 hat; q einen Wert von 0 bis 4 hat; jedes y unabhängig voneinander einen Durchschnittswert von 1 bis 5 hat; y' einen Durchschnittswert von 0 bis 3 hat und jedes z und z' unabhängig voneinander einen Wert von 0 bis 3 hat;

(2) dem Reaktionsprodukt von:

(a) wenigstens einem Epoxyharz wie unter (A-1-) definiert; und

(b) wenigstens einem zweiwertigen oder mehrwertigen Phenol, das durch die folgenden Formeln VII, VIII oder IX wiedergegeben wird:

FORMEL VII

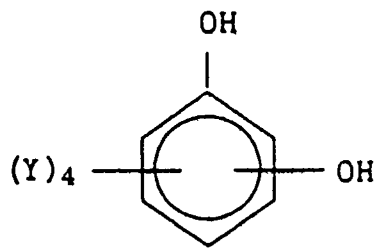

FORMEL VIII

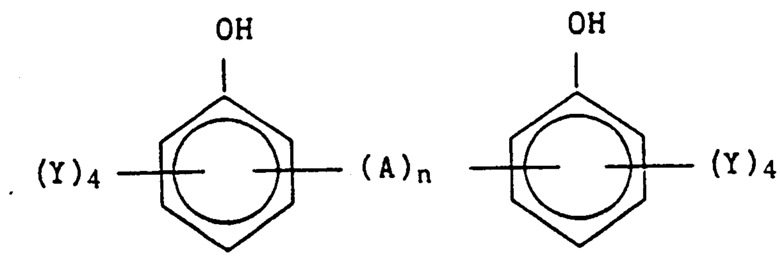

FORMEL (IX)

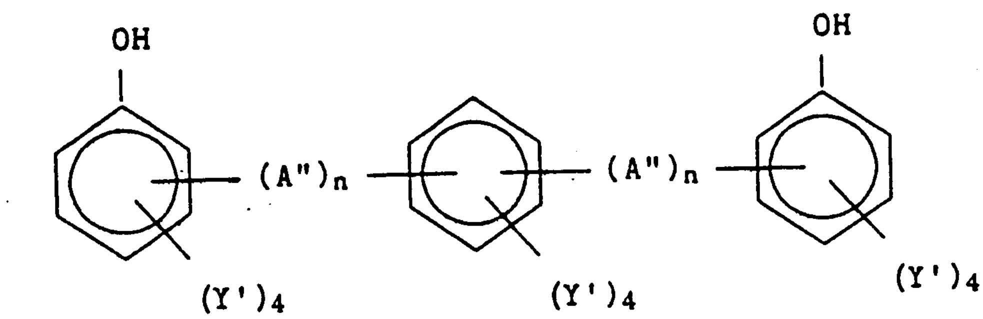

worin A ein zweiwertiger Kohlenwasserstoffrest mit 1 bis 12 Kohlenstoffatomen, -O-, -S-, -S-S-, -SO-, $-SO_2-$ oder -CO- ist, jedes Y unabhängig voneinander Wasserstoff, ein Halogen oder ein Kohlenwasserstoff- oder Kohlenwasserstoffoxy-rest mit 1 bis 10 Kohlenstoffatomen ist; jedes A" unabhängig voneinander ein zweiwertiger Kohlenwasserstoffrest mit 1 bis 6 Kohlenstoffatomen ist; jedes Y' unabhängig voneinander Wasserstoff, ein Kohlenwasserstoff- oder Kohlenwasserstoffoxy-rest mit 1 bis 10, vorzugsweise 1 bis 4 Kohlenstoffatomen, ein Halogenatom oder eine Hydroxylgruppe ist; und n einen Wert von 0 oder 1 hat; und worin die Bestandteile (A-2-a) und (A-2-b) in solchen Mengen vorhanden sind, daß das Verhältnis von phenolischen Hydroxylgruppen zu Epoxidgruppen von 0,01:1 bis 0,5:1 beträgt; oder

(3) Mischungen hiervon; und

(B) wenigstens einem halogenierten zweiwertigen Phenol, welches durch die folgenden Formeln X, XI oder XII wiedergegeben wird:

FORMEL X

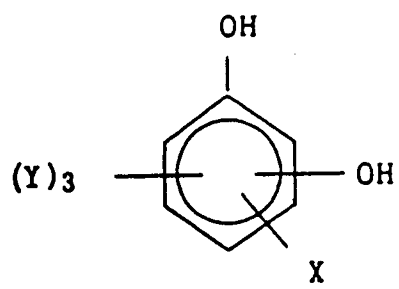

FORMEL XI

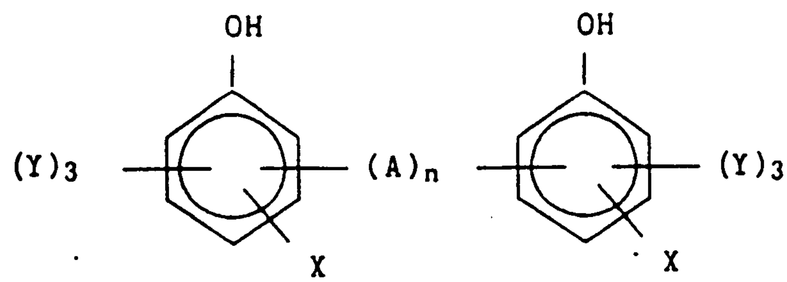

FORMEL XII

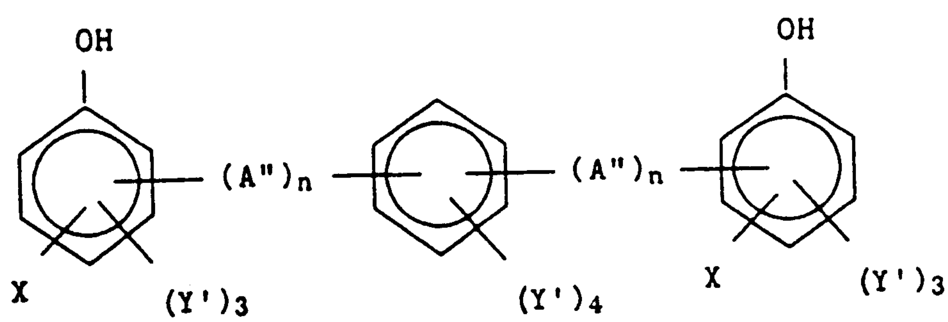

worin A, A", Y, Y' und n die zuvor angegebene Bedeutung besitzen; jedes X ein Halogen ist; und worin die Bestandteile (A) und (B) in solchen Mengen vorhanden sind, daß das Verhältnis von phenolischen Hydroxylgruppen zu Epoxidgruppen von 0,7:1 bis 1,1:1 beträgt,
gekennzeichnet durch Verwendung als wenigstens einem Teil des Bestandteiles (B) eines halogenierten zweiwertigen Phenols, worin wenigstens 5 Gew.-% der in dem Bestandteil (B) vorhandenen Halogenatome in der meta-Stellung zu den Hydroxylgruppen stehen.

**2.** Zusammensetzung nach Anspruch 1, worin die Bestandteile (A) und (B) in solchen Mengen vorhanden sind, daß das Verhältnis von phenolischen Hydroxylgruppen zu Epoxidgruppen von 0,85:1 bis 1:1 beträgt; und eine stabilisierende Menge eines Stabilisators, wiedergegeben durch die folgende Formel:

FORMEL XV.

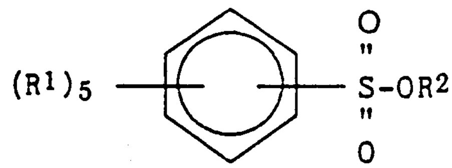

worin jedes $R^1$ unabhängig voneinander Wasserstoff, ein Kohlenwasserstoffrest mit 1 bis 10 Kohlenstoffatomen oder ein Halogen ist, und $R^2$ ein Kohlenwasserstoffrest mit 1 bis 10 Kohlenstoffatomen ist, vorhanden ist;
dadurch gekennzeichnet, daß
wenigstens 30 Gew.-% der in dem Bestandteil (B) vorhandenen Halogenatome in der meta-Stellung zu den Hydroxylgruppen stehen.

3. Zusammensetzung nach Anspruch 2, worin die Bestandteile (A) und (B) in solchen Mengen vorhanden sind, daß das Verhältnis von phenolischen Hydroxylgruppen zu Epoxidgruppen von 0,9:1 bis 0,95:1 beträgt; und dieser Stabilisator in einer Menge von 0,001 bis 10 Gew.-% des Gewichtes des Bestandteiles (A) vorhanden ist;
dadurch gekennzeichnet, daß
wenigstens 50 Gew.-% der in dem Bestandteil (B) vorhandenen Halogenatome in der meta-Stellung zu den Hydroxylgruppen stehen.

4. Zusammensetzung nach Anspruch 1 oder Anspruch 2, worin der Bestandteil (A) der durch die Formel I oder II wiedergegebene Bestandteil (A-1) ist, worin Q, R und R' Wasserstoff sind; q einen Durchschnittswert von 0,1 bis 2 besitzt, und der Bestandteil (B) durch die Formel XI wiedergegeben wird, worin A ein zweiwertiger Kohlenwasserstoffrest mit 1 bis 6 Kohlenstoffatomen ist und jedes X Brom bedeutet.

5. Zusammensetzung nach Anspruch 1 oder Anspruch 2, worin der Bestandteil (A) der durch die Formel III wiedergegebene Bestandteil (A-1) ist, worin A' 1 bis 4 Kohlenstoffatome besitzt und jedes R und R' Wasserstoff ist, und der Bestandteil (B) durch die Formel XI wiedergegeben wird, worin A ein zweiwertiger Kohlenwasserstoffrest mit 1 bis 6 Kohlenstoffatomen ist und jedes X Brom bedeutet.

6. Zusammensetzung nach Anspruch 1 oder 2, worin der Bestandteil (A) der durch die Formeln IV oder V wiedergegebene Bestandteil (A-1) ist, worin jedes Q, R und R' Wasserstoff ist, und der Bestandteil (B) durch die Formel XI wiedergegeben wird, worin A ein zweiwertiger Kohlenwasserstoffrest mit 1 bis 6 Kohlenstoffatomen ist und jedes X Brom bedeutet.

7. Zusammensetzung nach Anspruch 1 oder Anspruch 2, worin der Bestandteil (A) der durch die Formel VI wiedergegebene Bestandteil (A-1) ist, worin jedes Q und R' Wasserstoff ist, und der Bestandteil (B) durch die Formel XI wiedergegeben wird, worin A ein zweiwertiger Kohlenwasserstoffrest mit 1 bis 6 Kohlenstoffatomen ist und jedes X Brom bedeutet.

8. Zusammensetzung nach einem der Ansprüche 4 bis 7, worin der Bestandteil (B) 2,2',6,6'-Tetrabrom-3,3',5,5'-tetramethyl-4,4'-biphenoloder 2,2',6-Tribrom-3,3',5,5'-tetramethyl-4,4'-biphenol oder 4,4'-Methylen-bis-3,5-dibrom-2,6-dimethylphenol oder eine Mischung hiervon ist, und dieser Stabilisator Methyl-p-toluolsulfonat ist.

9. Zusammensetzung, welche umfaßt (I) eine Zusammensetzung nach einem der Ansprüche 1-8 und (II) eine katalytische Menge wenigstens eines Katalysators zur Herbeiführung der Reaktion zwischen den Bestandteilen (I-A) und (I-B).

10. Elektrisches Laminat, hergestellt aus einer oder mehreren Schichten eines mit einer Zusammensetzung von Anspruch 9 imprägnierten Substrates.

**Patentansprüche für folgende Vertragsstaaten : AT, ES**

**1.** Verfahren zur Herstellung einer Zusammensetzung, wobei diese Zusammensetzung umfaßt:
(A) wenigstens einen Bestandteil von:

(1) wenigstens einem Epoxyharz, wiedergegeben durch die folgenden Formeln I, II, III, IV, V oder VI

FORMEL I

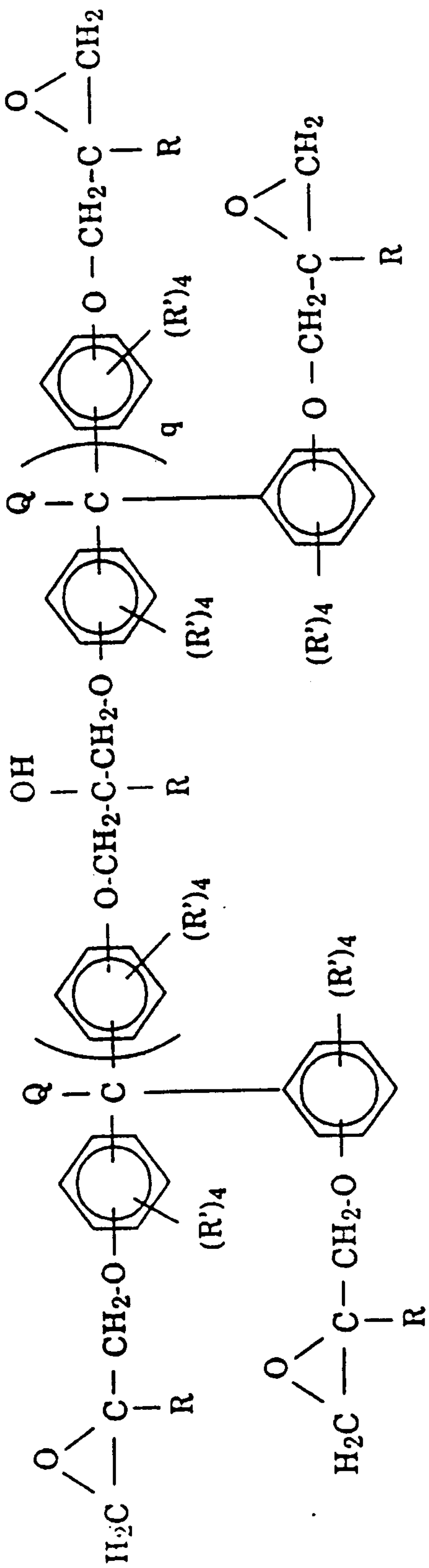

FORMEL II

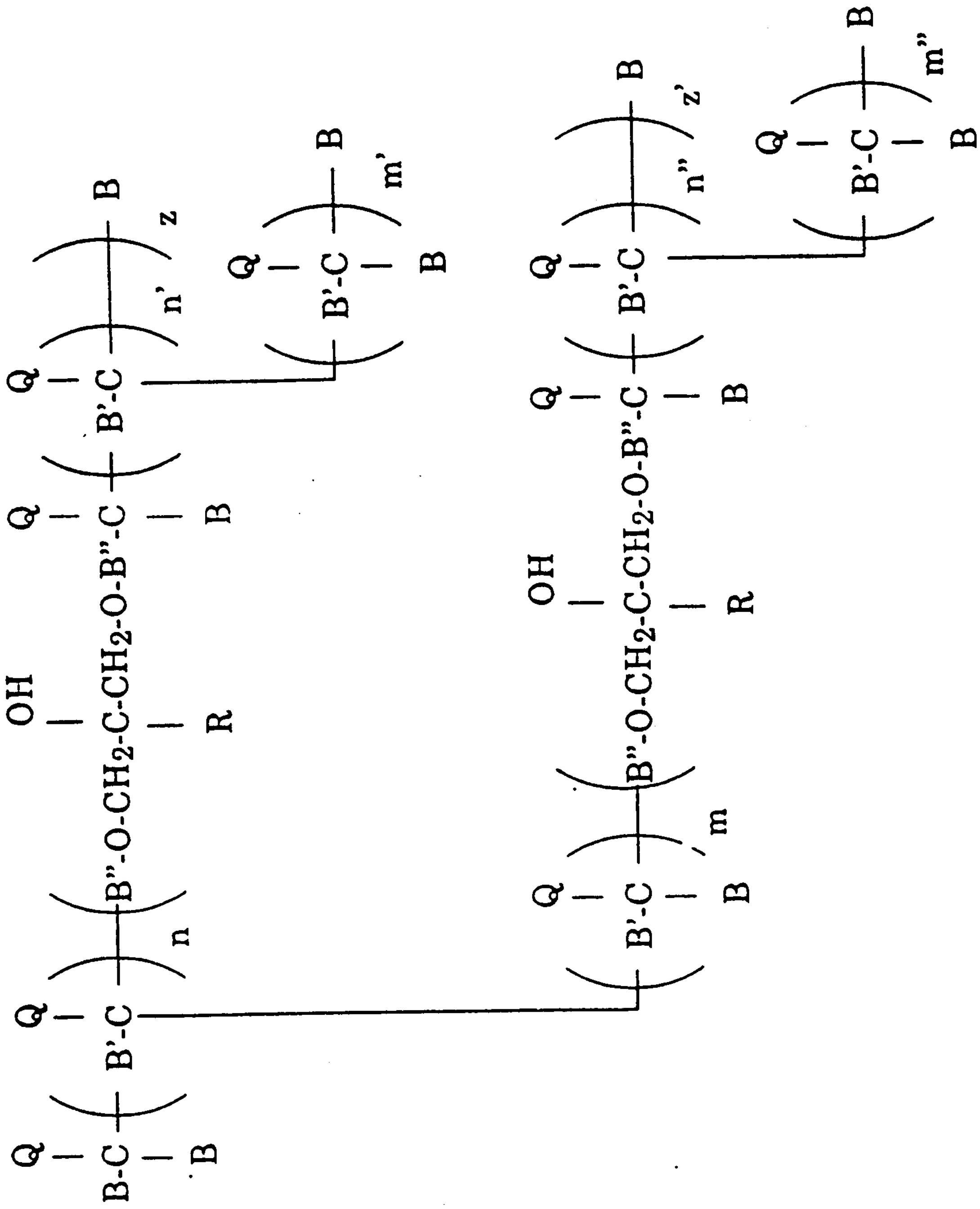

FORMEL III

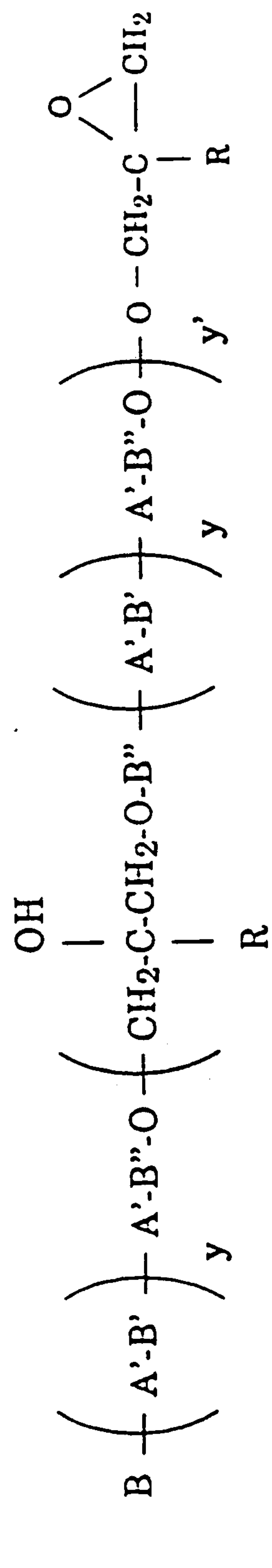

FORMEL IV

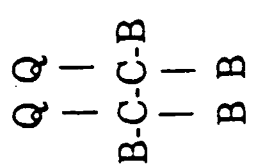

FORMEL V

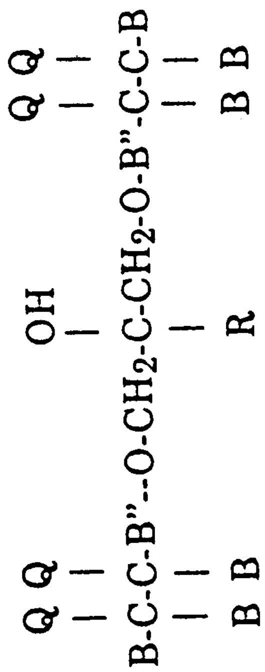

FORMEL VI

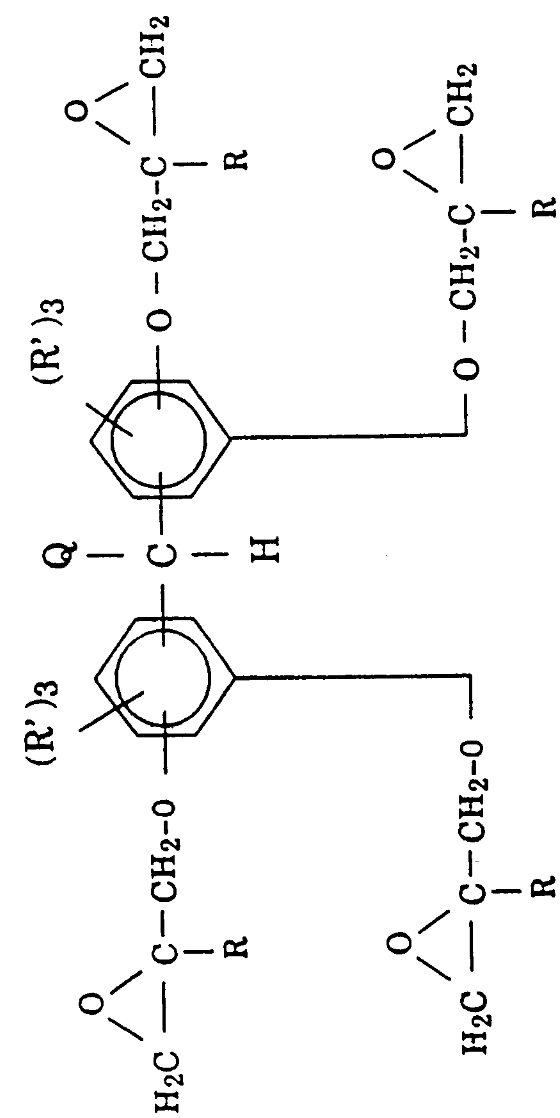

worin jedes A' unabhängig voneinander ein zweiwertiger Kohlenwasserstoffrest mit 1 bis 12 Kohlenstoffatomen, -S-, -S-S-, -SO-, $-SO_2-$, -CO- oder -O- ist;
jedes B durch die Formel:

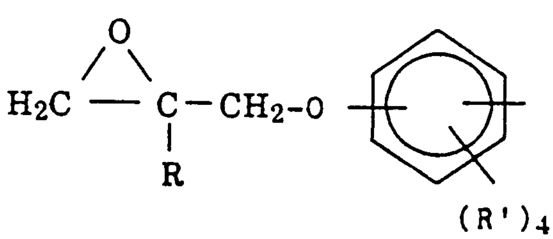

wiedergegeben wird,

jedes B' durch die Formel:

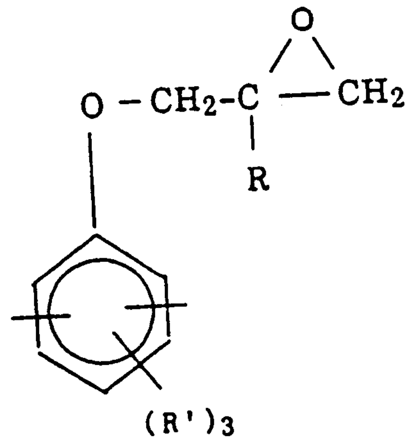

wiedergegeben wird,
jedes B" durch die Formel:

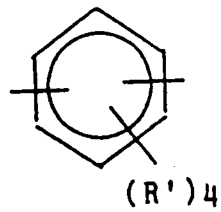

wiedergegeben wird,
jedes R unabhängig voneinander Wasserstoff oder ein Alkylrest mit 1 bis 4 Kohlenstoffatomen ist; jedes Q unabhängig voneinander Wasserstoff oder ein Kohlenwasserstoffrest mit 1 bis 10 Kohlenstoffatomen ist; jedes R' unabhängig voneinander Wasserstoff, ein Kohlenwasserstoff- oder Kohlenwasserstoffoxy-rest mit 1 bis 10 Kohlenstoffatomen oder ein Halogen ist; m einen Wert von n-1 hat; m' einen Wert von n'-1 hat; m" einen Wert von n"-1 hat, wobei jedes m, m' und m" wenigstens den Wert null besitzt; jedes n, n' und n" unabhängig voneinander einen Wert von 0 bis 3 hat; q einen Wert von 0 bis 4 hat; jedes y unabhängig voneinander einen Durchschnittswert von 1 bis 5 hat; y' einen Durchschnittswert von 0 bis 3 hat und jedes z und z' unabhängig voneinander einen Wert von 0 bis 3 hat;
(2) dem Reaktionsprodukt von:
(a) wenigstens einem Epoxyharz wie unter (A-1-) definiert; und

(b) wenigstens einem zweiwertigen oder mehrwertigen Phenol, das durch die folgenden Formeln VII, VIII oder IX wiedergegeben wird:

FORMEL VII

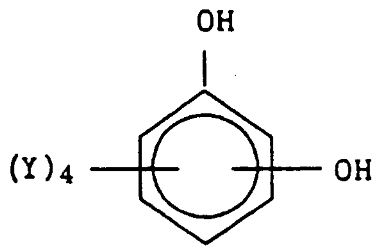

FORMEL VIII

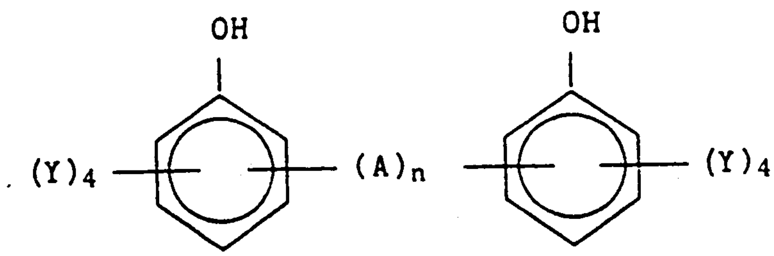

FORMEL (IX)

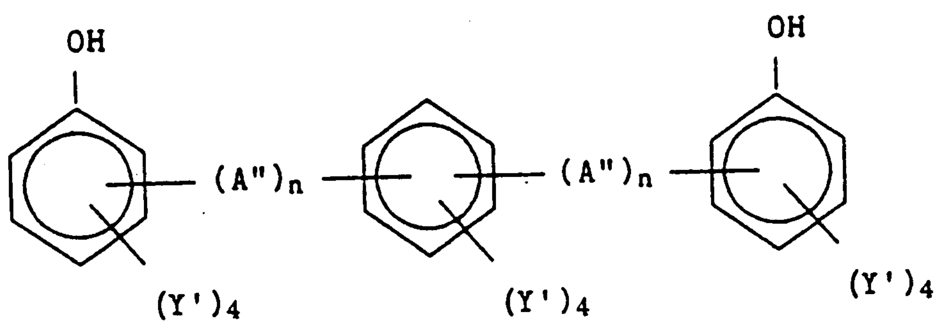

worin A ein zweiwertiger Kohlenwasserstoffrest mit 1 bis 12 Kohlenstoffatomen, -O-, -S-, -S-S-, -SO-, $-SO_2-$ oder -CO- ist, jedes Y unabhängig voneinander Wasserstoff, ein Halogen oder ein Kohlenwasserstoff- oder Kohlenwasserstoffoxy-rest mit 1 bis 10 Kohlenstoffatomen ist; jedes A" unabhängig voneinander ein zweiwertiger Kohlenwasserstoffrest mit 1 bis 6 Kohlenstoffatomen ist; jedes Y' unabhängig voneinander Wasserstoff, ein Kohlenwasserstoff- oder Kohlenwasserstoffoxy-rest mit 1 bis 10, vorzugsweise 1 bis 4 Kohlenstoffatomen, ein Halogenatom oder eine Hydroxylgruppe ist; und n einen Wert von 0 oder 1 hat; und worin die Bestandteile (A-2-a) und (A-2-b) in solchen Mengen vorhanden sind, daß das Verhältnis von phenolischen Hydroxylgruppen zu Epoxidgruppen von 0,01:1 bis 0,5:1 beträgt; oder

(3) Mischungen hiervon; und

(B) wenigstens einem halogenierten zweiwertigen Phenol, welches durch die folgenden Formeln X, XI oder XII wiedergegeben wird:

FORMEL X

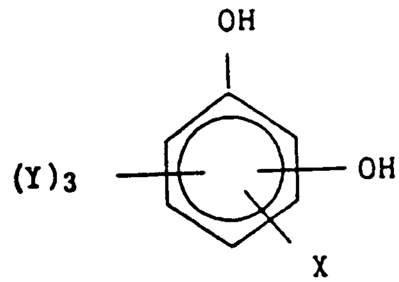

FORMEL XI

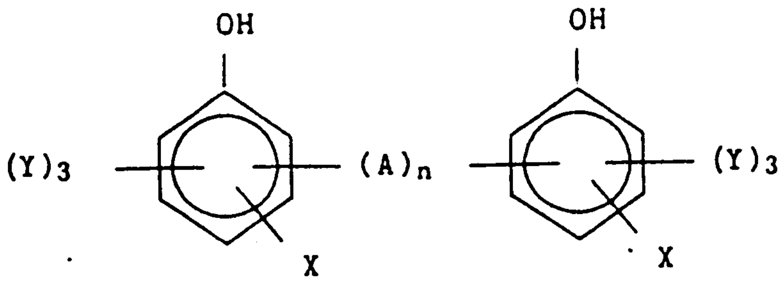

FORMEL XII

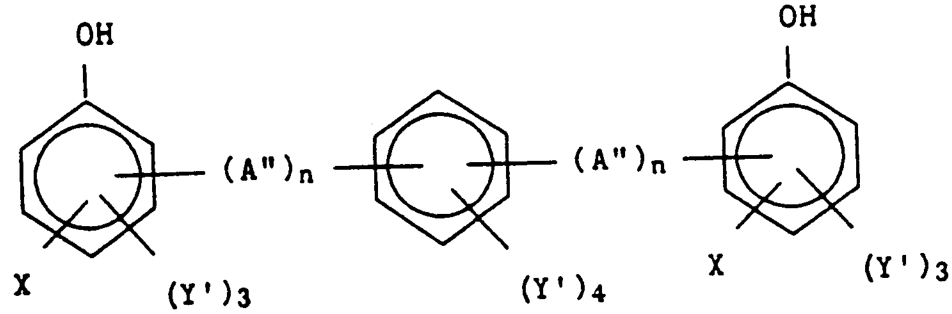

worin A, A", Y, Y' und n die zuvor angegebene Bedeutung besitzen; jedes X ein Halogen ist;
durch Vermischen der Bestandteile (A) und (B) in solchen Mengen, daß das Verhältnis von phenolischen Hydroxylgruppen zu Epoxidgruppen von 0,7:1 bis 1,1:1 beträgt,
wobei dieses Verfahren dadurch gekennzeichnet ist, daß als wenigstens ein Teil des Bestandteiles (B) ein halogeniertes, zweiwertiges Phenol, worin wenigstens 5 Gew.-% der in dem Bestandteil (B) vorhandenen Halogenatome in der meta-Stellung zu den Hydroxylgruppen stehen, verwendet wird.

**2.** Verfahren nach Anspruch 1, worin die Bestandteile (A) und (B) in solchen Mengen vermischt werden, daß das Verhältnis von phenolischen Hydroxylgruppen zu Epoxidgruppen von 0,85:1 bis 1:1 beträgt; und eine stabilisierende Menge eines Stabilisators, wiedergegeben durch die folgende Formel:

FORMEL XV.

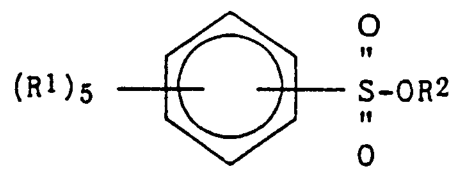

worin jedes $R^1$ unabhängig voneinander Wasserstoff, ein Kohlenwasserstoffrest mit 1 bis 10 Kohlenstoffatomen oder ein Halogen ist, und $R^2$ ein Kohlenwasserstoffrest mit 1 bis 10 Kohlenstoffatomen ist, vorhanden ist;
dadurch gekennzeichnet, daß
wenigstens 30 Gew.-% der in dem Bestandteil (B) vorhandenen Halogenatome in der meta-Stellung zu den Hydroxylgruppen stehen.

**3.** Verfahren nach Anspruch 2, worin die Bestandteile (A) und (B) in solchen Mengen vermischt werden, daß das Verhältnis von phenolischen Hydroxylgruppen zu Epoxidgruppen von 0,9:1 bis 0,95:1 beträgt; und dieser Stabilisator in einer Menge von 0,001 bis 10 Gew.-% des Gewichtes des Bestandteiles (A) vorhanden ist;
dadurch gekennzeichnet, daß
wenigstens 50 Gew.-% der in dem Bestandteil (B) vorhandenen Halogenatome in der meta-Stellung zu den Hydroxylgruppen stehen.

**4.** Verfahren nach einem der Ansprüche 1 bis 3, worin der Bestandteil (A) der durch die Formel I oder II wiedergegebene Bestandteil (A-1) ist, worin Q, R und R' Wasserstoff sind; q einen Durchschnittswert von 0,1 bis 2 besitzt, und der Bestandteil (B) durch die Formel XI wiedergegeben wird, worin A ein zweiwertiger Kohlenwasserstoffrest mit 1 bis 6 Kohlenstoffatomen ist und jedes X Brom bedeutet.

**5.** Verfahren nach einem der Ansprüche 1 bis 3, worin der Bestandteil (A) der durch die Formel III wiedergegebene Bestandteil (A-1) ist, worin A' 1 bis 4 Kohlenstoffatome besitzt und jedes R und R' Wasserstoff ist, und der Bestandteil (B) durch die Formel XI wiedergegeben wird, worin A ein zweiwertiger Kohlenwasserstoffrest mit 1 bis 6 Kohlenstoffatomen ist und jedes X Brom bedeutet.

**6.** Verfahren nach einem der Ansprüche 1 bis 3, worin der Bestandteil (A) der durch die Formeln IV oder V wiedergegebene Bestandteil (A-1) ist, worin jedes Q, R und R' Wasserstoff ist, und der Bestandteil (B) durch die Formel XI wiedergegeben wird, worin A ein zweiwertiger Kohlenwasserstoffrest mit 1 bis 6 Kohlenstoffatomen ist und jedes X Brom bedeutet.

**7.** Verfahren nach einem der Ansprüche 1 bis 3, worin der Bestandteil (A) der durch die Formel VI wiedergegebene Bestandteil (A-1) ist, worin jedes Q und R' Wasserstoff ist, und der Bestandteil (B) durch die Formel XI wiedergegeben wird, worin A ein zweiwertiger Kohlenwasserstoffrest mit 1 bis 6 Kohlenstoffatomen ist und jedes X Brom bedeutet.

**8.** Verfahren nach einem der Ansprüche 4 bis 7, worin der Bestandteil (B) 2,2',6,6'-Tetrabrom-3,3',5,5'-tetramethyl-4,4'-biphenoloder 2,2',6-Tribrom-3,3',5,5'-tetramethyl-4,4'-biphenol oder 4,4'-Methylen-bis-3,5-dibrom-2,6-dimethylphenol oder eine Mischung hiervon ist, und dieser Stabilisator Methyl-p-toluolsulfonat ist.

**9.** Verfahren zur Herstellung einer Zusammensetzung, wobei das Verfahren das Vermischen (I) einer Zusammensetzung eines beliebigen der Ansprüche 1 bis 8 und (II) einer katalytischen Menge wenigstens eines Katalysators zur Herbeiführung der Reaktion zwischen den Bestandteilen (I-A) und (I-B) umfaßt.

**10.** Verfahren zur Herstellung eines elektrischen Laminates, wobei das Verfahren das Imprägnieren von einer oder mehreren Schichten eines Substrates mit einer Zusammensetzung von Anspruch 9 umfaßt.